# EUROPEAN PATENT APPLICATION

(11) **EP 4 842 178 A1**
(43) Date of publication of application: **18.11.2026**
(21) Application number: 26165269.7
(22) Date of filing: 17.03.2026
(51) Int. Cl.: H10K 59/80

(54) **DISPLAY DEVICE, METHOD FOR MANUFACTURING DISPLAY DEVICE, AND AUTOMOBILE INCLUDING DISPLAY DEVICE**

(30) Priority: 12.05.2025 KR 20250060940
(71) Applicant: Samsung Display Co., Ltd., Yongin-si, Gyeonggi-do 17113 (KR)
(72) Inventor: Kim, Hyang Yul, Yongin-si, Gyeonggi-do (KR); Kim, Hyun Chul, Yongin-si, Gyeonggi-do (KR); Lee, Chang Han, Yongin-si, Gyeonggi-do (KR)
(74) Representative: Gulde & Partner

(57) **Abstract**

Provided are a display device, a method for manufacturing display device, and an automobile including display device. The display device includes a display panel including a main display area and a sub-display area surrounded by the main display area, each of the main display area and the sub-display area including a plurality of light emitting elements, and a light control film disposed on the display panel. The light control film includes a base film, a light transmissive layer disposed on the base film and including a plurality of grooves, and a plurality of louvers respectively disposed within the plurality of grooves, wherein the plurality of louvers include a light transmitting louver overlapping the sub-display area and a light blocking louver overlapping the main display area.

## Description

### BACKGROUND

### 1. Field

The present disclosure relates to a display device, a method for manufacturing the display device, and an automobile including the display device.

### 2. Description of the Related Art

As an information society develops, the demand for a display device for displaying an image is increasing in various forms. The display devices may be displays such as liquid crystal displays (LCDs), field emission displays (FEDs), or light emitting displays (LEDs). A light emitting display may include an organic light emitting display device including an organic light emitting diode element as a light emitting element, or an inorganic light emitting display device including an inorganic light emitting diode element as a light emitting element.

The display device may include various optical devices such as an image sensor for capturing an image of the front, a proximity sensor for sensing whether a user is positioned close to the front of the display device, an illumination sensor for sensing an illuminance of the front of the display device, and an iris sensor for recognizing an iris of the user.

As display devices are applied to various electronic devices, display devices having various designs are desired. For example, in the case of smartphones, there is a demand for a display device that may expand a display area by deleting a hole disposed on the front of the display device. In this case, the optical device disposed in the hole disposed on the front of the display device may be disposed to overlap a display panel.

In the case of a vehicle display device, when an image displayed on the vehicle display device disposed in front of a driver or passenger is reflected on a windshield at night, it may interfere with the driver's driving, and therefore, it is desired to control a viewing angle of the image displayed on the vehicle display device. In some aspects, for purpose of protecting privacy, in order to prevent images displayed on a vehicle display device disposed in front of the driver from being provided to passengers, or to prevent images displayed on a vehicle display device disposed in front of passengers from being provided to drivers, it is desired to control the viewing angle of the images displayed on the vehicle display device.

### SUMMARY

Aspects of the present disclosure provide a display device capable of controlling a viewing angle, a method for manufacturing the display device, and an automobile including the display device.

Aspects of the present disclosure also provide a display device having improved transmittance of a sub-display area, a method for manufacturing the display device, and an automobile including the display device.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to an aspect of the present disclosure, there is provided a display device including, a display panel including a main display area and a sub-display area surrounded by the main display area, each of the main display area and the sub-display area including a plurality of light emitting elements, and a light control film disposed on the display panel and including, a base film, a light transmissive layer disposed on the base film and including a plurality of grooves, and a plurality of louvers respectively disposed within the plurality of grooves, wherein the plurality of louvers include a light transmitting louver overlapping the sub-display area and a light blocking louver overlapping the main display area.

In an embodiment, grooves overlapping both the main display area and the sub-display area among the plurality of grooves include both the light transmitting louver and the light blocking louver.

In an embodiment, a first boundary line that separates the main display area and the sub-display area is surrounded by a second boundary line connecting boundaries of the light transmitting louver and the light blocking louver.

In an embodiment, a light transmissive area defined by the second boundary line is greater than the sub-display area.

In an embodiment, the light transmissive area defined by the second boundary line is elliptical in a plan view.

In an embodiment, the light transmissive area has a long axis in an extension direction of the grooves in the plan view.

In an embodiment, in the plan view, a first direction in which the plurality of light emitting elements are aligned in the main display area and the sub-display area intersects a second direction in which the plurality of louvers extend.

In an embodiment, an angle formed by the first direction and the second direction is less than 30 degrees.

In an embodiment, the sub-display area further includes a transmissive area disposed between the plurality of light emitting elements.

In an embodiment, the light transmitting louver overlaps the transmissive area.

In an embodiment, the display device may further include an optical device overlapping the sub-display area, wherein the optical device overlaps the light transmitting louver.

In an embodiment, the sub-display area further includes a transmissive area disposed between the plurality of light emitting elements, and the optical device overlaps the transmissive area.

In an embodiment, a density of the plurality of light emitting elements in the sub-display area is smaller than a density of the plurality of light emitting elements in the main display area.

In an embodiment, upper surfaces of the plurality of louvers are spaced apart from an interface between the base film and the light transmissive layer.

A method for manufacturing a display device, the method including, providing a display panel including a main display area and a sub-display area surrounded by the main display area, and providing a light control film including a base film, applying a first ink including a liquid transparent resin onto the base film, forming a light transmissive layer and a plurality of grooves by compressing the first ink using a mold and curing the first ink, forming a light transmitting louver by applying a second ink including a liquid transparent resin to first grooves overlapping the sub-display area among the plurality of grooves and curing the second ink, forming a light blocking louver by applying a third ink including a liquid transparent resin to second grooves overlapping the main display area among the plurality of grooves and curing the third ink, and bonding the light control film to the display panel.

In an embodiment, the third ink is applied such that the third ink is positioned on an upper surface of the light transmissive layer and an upper surface of the light transmitting louver, and the method further includes removing the third ink positioned on the upper surface of the light transmissive layer and the upper surface of the light transmitting louver using a blade.

In an embodiment, the mold includes a roller or a jig.

In an embodiment, the mold includes a pattern portion, and the first ink is cured along a shape of the pattern portion.

In an embodiment, the light control film and the display panel are bonded to each other by an adhesive layer interposed between the light control film and the display panel.

According to an aspect of the present disclosure, there is provided an automobile including, a body, an interior space surrounded by the body and including a dashboard, and a display device disposed on the dashboard and which displays an image, wherein the display device includes, a display panel including a main display area and a sub-display area surrounded by the main display area, each of the main display area and the sub-display area including a plurality of light emitting elements, and a light control film disposed on the display panel and including, a base film, a light transmissive layer disposed on the base film and including a plurality of grooves, and a plurality of louvers respectively disposed within the plurality of grooves, wherein the plurality of louvers include a light transmitting louver overlapping the sub-display area and a light blocking louver overlapping the main display area.

According to the display device, the method for manufacturing the display device, and the automobile including the display device according to the embodiments of the present disclosure, the viewing angle may be controlled.

According to the display device, the method for manufacturing the display device, and the automobile including the display device according to the embodiments of the present disclosure, the transmittance of the sub-display area may be improved.

However, the effects of the embodiments are not restricted to the one set forth herein. The above and other effects of the embodiments will become more apparent to one of ordinary skill in the art to which the embodiments pertain by referencing the claims.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view illustrating a display device according to an embodiment;
FIG. 2 is a plan view illustrating a display device according to an embodiment;
FIG. 3 is a cross-sectional view illustrating the display device taken along line X1-X1' of FIG. 2;
FIG. 4 is a schematic view illustrating an example of applying the display device according to an embodiment to an automobile;
FIG. 5 is a schematic view illustrating another example of applying the display device according to an embodiment to an automobile;
FIG. 6 is a cross-sectional view illustrating an example of a display panel according to an embodiment;
FIG. 7 is an enlarged view of area A of FIG. 2;
FIG. 8 is an enlarged view of area B of FIG. 7;
FIG. 9 is a plan view illustrating a light control film according to an embodiment;
FIG. 10 is a cross-sectional view taken along line X3-X3' of FIG. 9;
FIG. 11 is an enlarged view of area C of FIG. 8;
FIG. 12 is a plan view illustrating an example of a display area and a light transmissive area of a display device according to an embodiment;
FIG. 13 is a plan view illustrating another example of a display area and a light transmissive area of a display device according to an embodiment;
FIG. 14 is a cross-sectional view for describing an operation of the display device according to an embodiment;
FIG. 15 is a flowchart illustrating a method for manufacturing a display device according to an embodiment;
FIG. 16 is a cross-sectional view illustrating step S100 of FIG. 15;
FIGS. 17 to 19 are cross-sectional views illustrating step S200 of FIG. 15;
FIGS. 20 and 21 are cross-sectional views illustrating step S300 of FIG. 15;
FIG. 22 is a plan view illustrating step S300 of FIG. 15;
FIG. 23 is a cross-sectional view illustrating step S400 of FIG. 15;
FIG. 24 is a cross-sectional view illustrating step S500 of FIG. 15;
FIG. 25 is a cross-sectional view illustrating step S600 of FIG. 15;
FIG. 26 is a cross-sectional view illustrating step S700 of FIG. 15;
FIG. 27 is a block diagram of an electronic device according to an embodiment; and
FIG. 28 illustrates schematic diagrams of electronic devices according to various embodiments.

### DETAILED DESCRIPTION

The invention will now be described more fully hereinafter with reference to the accompanying drawings, in which example embodiments of the present disclosure are illustrated. Aspects supported by the present disclosure may, however, be embodied in different forms and should not be construed as limited to the embodiments set forth herein. Rather, the example embodiments are provided such that this disclosure will be thorough and complete, and will fully convey the scope of example aspects of the present disclosure to those skilled in the art.

It will also be understood that when a layer is referred to as being "on" another layer or substrate, it can be directly on the other layer or substrate, or intervening layers may also be present. The same reference numbers indicate the same components throughout the specification.

Terms such as, for example, first, second, and the like may be used to describe various components, but the components should not be limited by the terms. The terms as used herein may distinguish one component from other components and are not to be limited by the terms. For example, without departing from the scope of the present disclosure, a first component may be referred to as a second component, and similarly, the second component may also be referred to as the first component. The terms of a singular form may include plural forms unless otherwise specified.

The terminology used herein is for the purpose of describing particular embodiments and is not intended to be limiting. As used herein, "a," "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, or components.

The terms "about" or "approximately" as used herein are inclusive of the stated value and include a suitable range of deviation for the particular value as determined by one of ordinary skill in the art, considering the measurement in question and the error associated with measurement of the particular quantity. The terms "about" or "approximately" can mean within one or more standard deviations, or within ± 30%, 20%, 10%, 5% of the stated value, for example.

The term "substantially," as used herein, means approximately or actually. The term "substantially equal" means approximately or actually equal. The term "substantially the same" means approximately or actually the same. The term "substantially identical" means approximately or actually identical. The term "substantially perpendicular" means approximately or actually perpendicular.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

Embodiments are described herein with reference to cross section illustrations that are schematic illustrations of example embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases.

Hereinafter, embodiments of the present disclosure will be described in detail with reference to the accompanying drawings.

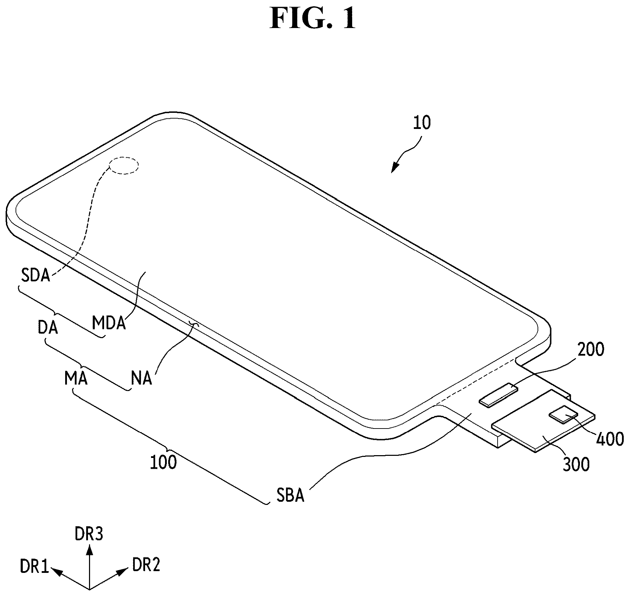

FIG. 1 is a perspective view illustrating a display device according to an embodiment.

Referring to FIG. 1, a display device 10 is a device that displays a moving image or a still image, and may be used as a display screen of each of various products such as televisions, laptop computers, monitors, billboards, and Internet of Things (IoT) as well as portable electronic devices such as mobile phones, smartphones, tablet personal computers (PCs), smartwatches, watch phones, mobile communication terminals, electronic organizers, electronic books, portable multimedia players (PMPs), navigation devices, and ultra mobile PCs (UMPCs).

The display device 10 may be a light emitting display device such as an organic light emitting display device including an organic light emitting diode, a quantum dot light emitting display device including a quantum dot light emitting layer, an inorganic light emitting display device including an inorganic semiconductor, and a micro or nano light emitting display device using a micro or nano light emitting diode (micro or nano LED). Hereinafter, an embodiment in which the display device 10 is an organic light emitting display device is described, but the type of the display device 10 is not limited thereto.

In an embodiment, the display device 10 may be formed to be flat. For example, the display device 10 may be substantially flat on a plane defined by a first direction DR1 and a second direction DR2 and may have a selected thickness (or height) in a third direction DR3. In another embodiment, the display device 10 may include a curved portion in at least one portion, including an edge area. In some aspects, the display device 10 may be flexibly formed to be curved, bent, folded, or rolled.

In the illustrated drawings, the first direction DR1 and the second direction DR2 are horizontal directions and intersect each other. For example, the first direction DR1 and the second direction DR2 may be orthogonal to each other. In some aspects, the third direction DR3 may be a vertical direction intersecting the first direction DR1 and the second direction DR2, for example, orthogonal to the first direction DR1 and the second direction DR2. Unless otherwise defined, in the present specification, directions indicated by arrows in the first to third directions DR1, DR2, and DR3 may be referred to as one side, and the opposite directions thereof may be referred to as the other side. In some aspects, in the present specification, "on", "upper side", "upper portion", "top", and "upper surface" refer to a direction in which an arrow in the drawing is directed in a third direction DR3 based on the drawing, and "below", "lower side", "lower portion", "bottom", and "lower surface" refer to a direction opposite to the direction in which the arrow in the third direction DR3 is directed based on the drawing.

The display device 10 may include a display panel 100, a display driver 200, a circuit board 300, and a touch driver 400.

The display panel 100 may include a main area MA including a display area DA where an image is displayed, and a sub-area SBA positioned on one side of the main area MA.

The main area MA may include a display area DA and a non-display area NA around the display area DA. The display area DA may be positioned at the center of the main area MA and may occupy most of the area of the main area MA. The non-display area NA may be positioned at an edge of the main area MA and may be in contact with the sub-area SBA.

The display area DA is an area where pixels are arranged and may be an area where an image is displayed by the pixels. In an embodiment, the display area DA may further be provided with sensing patterns (e.g., touch electrodes) for sensing a touch input, or the like, and may include a sensing area that senses the touch input by the sensing patterns.

In an embodiment, the display area DA may be formed as a plane including long sides in the first direction DR1 and short sides in the second direction DR2 and having a substantially rectangular shape. A corner portion where the long side and the short side of the display area DA meet may be rounded or formed at a right angle. The shape of the display area DA may be variously changed depending on the embodiments. For example, the display area DA may be formed in a polygonal shape other than the quadrangular shape, a circular shape, an elliptical shape, or the like.

The display area DA may include a main display area MDA and a sub-display area SDA. The sub-display area SDA is an area where components for adding various functions to the display device 10 are disposed, and the sub-display area SDA may correspond to a component area.

The non-display area NA may be disposed directly around the display area DA. The non-display area NA may surround the display area DA. Embedded circuits may be disposed in the non-display area NA. For example, embedded circuits including a scan driving circuit, or the like, may be disposed in the non-display area NA positioned on one side (e.g., the left or right side) or both sides of the display area DA.

The sub-area SBA may be positioned on one side of the main area MA. For example, the sub-area SBA may be an area that protrudes in the first direction DR1 from one side of the main area MA. As an example, the sub-area SBA may protrude in the first direction DR1 from a lower end of the main area MA. In an embodiment, the sub-area SBA may have a narrower width than the main area MA. For example, with respect to the second direction DR2, the sub-area SBA may have a narrower width than the main area MA.

Lines and pads can be disposed in the sub-area SBA. For example, in the sub-area SBA, the pixels and/or embedded circuits positioned in the main area MA, the display driver 200 positioned in the sub-area SBA, and/or the lines and pads connected to the circuit board 300 may be disposed. In describing the embodiments, "connection" may include electrical connection and/or physical connection.

In an embodiment, the display driver 200 (e.g., a display driver circuit) may be mounted on the sub-area SBA. The circuit board 300 may be disposed on a portion of the sub-area SBA.

The display driver 200 may include a data driving circuit for driving the pixels. In an embodiment, the display driver 200 may be formed as an integrated circuit chip IC and disposed in the sub-area SBA. In another embodiment, the display driver 200 may be disposed on the circuit board 300 on the sub-area SBA, or may be disposed on another circuit board connected to the display panel 100 through the circuit board 300.

The circuit board 300 may be disposed on a portion of the sub-area SBA. For example, the circuit board 300 may be bonded on the pads positioned at a portion (e.g., a lower edge) of the sub-area SBA and may supply or transmit power voltages and driving signals for driving the display panel 100 to the display panel 100. For example, the circuit board 300 may supply input image data (e.g., digital image data), driving signals including timing signals, and driving voltages to the display panel 100. The circuit board 300 may be a flexible film such as a flexible printed circuit board (FPCB), a printed circuit board (PCB), or a chip on film (COF), but is not limited thereto.

The touch driver 400 may be mounted on the circuit board 300. The touch driver 400 may be connected to a touch sensing unit of the display panel 100. The touch driver 400 may supply a touch driving signal to a plurality of touch electrodes of the touch sensing unit, and may sense an amount of change in capacitance between the plurality of touch electrodes. For example, the touch driving signal may be a pulse signal having a selected frequency. The touch driver 400 may calculate whether an input is made and input coordinates based on the amount of change in capacitance between the plurality of touch electrodes. The touch driver 400 may be formed as an integrated circuit (IC).

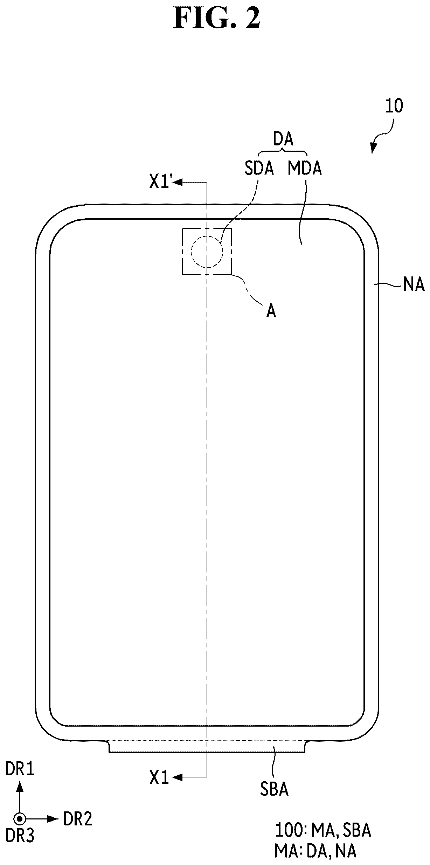

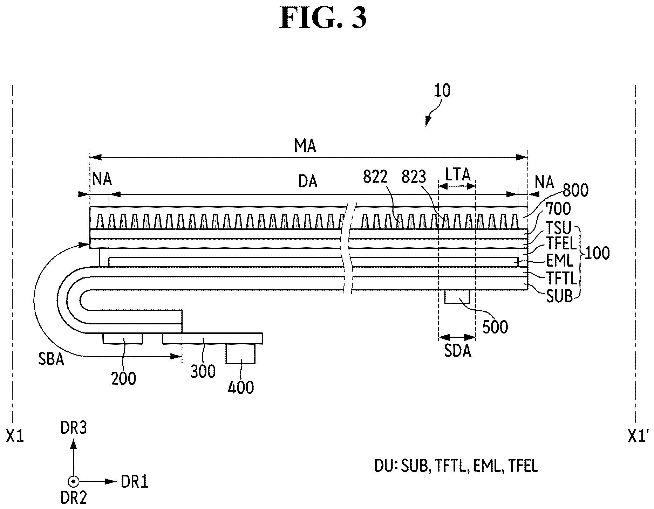

FIG. 2 is a plan view illustrating a display device according to an embodiment. FIG. 3 is a cross-sectional view illustrating the display device taken along line X1-X1' of FIG. 2.

Referring to FIGS. 2 and 3, a display device 10 according to an embodiment may include a display panel 100, an optical device 500, a polarizing film 700, and a light control film 800.

The display panel 100 may include a substrate SUB including a main area MA and a sub-area SBA, and a circuit layer TFTL, a light emitting element layer EML, an encapsulation layer TFEL, and a touch sensing layer TSU sequentially disposed on the substrate SUB. The circuit layer TFTL may also be positioned in the main area MA and sub-area SBA on the substrate SUB. The light emitting element layer EML and the encapsulation layer TFEL may be positioned on a portion of the substrate SUB and the circuit layer TFTL. For example, the light emitting element layer EML and the encapsulation layer TFEL may be positioned in the main area MA.

The substrate SUB may include an insulating material such as polymer resin. For example, the substrate SUB may include polyimide or another insulating material. The substrate SUB may be a flexible substrate capable of being deformed such as bending, folding, and rolling. Alternatively, the substrate SUB may also include an insulating material such as glass.

The circuit layer TFTL may include pixel circuits and lines. For example, the circuit layer TFTL may include circuit elements (e.g., pixel transistors and a capacitor) that constitute the pixel circuit of each pixel and lines connected to the pixels. In an embodiment, the circuit layer TFTL may further include circuit elements that constitute the embedded circuits such as the scan driving circuit and lines connected to the embedded circuit.

The light emitting element layer EML may include light emitting elements disposed in light emitting areas of the pixels. For example, each of the pixels may include at least one light emitting element and a pixel circuit connected to the light emitting element. Each of the pixels may be positioned in a pixel area including a light emitting area in which the light emitting element is disposed and a pixel circuit area in which the pixel circuit is disposed. The light emitting area and the pixel circuit area of each pixel may overlap each other, but are not limited thereto.

In describing the embodiments, the circuit layer TFTL and the light emitting element layer EML are separately described as different layers, but the embodiments are not limited thereto. For example, the circuit layer TFTL and the light emitting element layer EML may also be integrated.

The encapsulation layer TFEL may cover the light emitting element layer EML and extend into the non-display area NA to be in contact with the circuit layer TFTL. In an embodiment, the encapsulation layer TFEL may have a multilayer structure including at least two inorganic encapsulation films overlapping each other and at least one organic encapsulation film interposed between the inorganic encapsulation films.

The touch sensing layer TSU may be disposed on the encapsulation layer TFEL. The touch sensing layer TSU may include a plurality of touch electrodes for sensing a user's touch in a capacitance method, and touch lines connecting the plurality of touch electrodes and the touch driver 400. For example, the touch sensing layer TSU may sense the user's touch in a mutual capacitance method or a self-capacitance method.

In another embodiment, the touch sensing layer TSU may be disposed on a separate substrate disposed on the display panel 100. In this case, the substrate supporting the touch sensing layer TSU may be a base member that encapsulates the display panel 100.

The plurality of touch electrodes of the touch sensing layer TSU may be disposed in a touch sensor area overlapping the display area DA. The touch lines of the touch sensing layer TSU may be disposed in a touch peripheral area overlapping the non-display area NA.

The display panel 100 may be bent in a bending area BA. The bending area BA may be a portion of the sub-area SBA and may be spaced apart from the main area MA.

The substrate SUB and the circuit layer TFTL may be bent in a bending area BA corresponding to a partial section of the sub-area SBA. Accordingly, a bezel area perceived by the user as the non-display area NA may be reduced or minimized.

The optical device 500 may be disposed in the sub-display area SDA. The optical device 500 may emit or receive light of infrared, ultraviolet, and visible light bands. For example, the optical device 500 may be an optical sensor that senses light incident on the display device 10, such as a proximity sensor, an illumination sensor, and a camera sensor or an image sensor.

The polarizing film 700 may be disposed on the display panel 100. The polarizing film 700 may reduce reflection of external light by adjusting a phase of the external light incident on the polarizing film 700. In some embodiments, the polarizing film 700 may include a first base member, a linear polarizing plate, a phase retardation film such as a quarter-waver (λ/4) plate, and a second base member. The first base member, the phase retardation film, the linear polarizing plate, and the second base member of the polarizing film 700 may be sequentially stacked on the display panel 100.

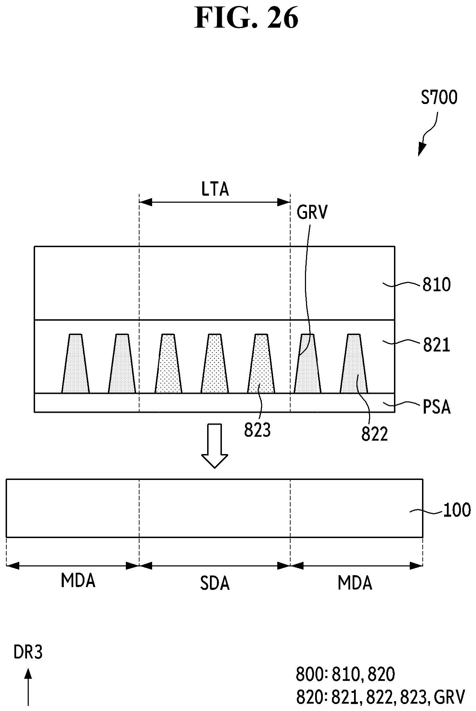

The light control film 800 may be disposed on the display panel 100. The light control film 800 may be manufactured separately from the display panel 100 and attached onto the display panel 100 (or the polarizing film 700). The light control film 800 may include an adhesive layer PSA (see FIG. 26) to which a release film is attached prior to attachment to the display panel 100 (or the polarizing film 700). In an example in which the light control film 800 is attached onto the display panel 100 (or the polarizing film 700), the release film may be removed and the display panel 100 (or the polarizing film 700) and the light control film 800 may be bonded to each other through the adhesive layer PSA (see FIG. 26).

The light control film 800 may be disposed to overlap the display area DA. The light control film 800 may serve to absorb or block light that travels beyond a certain angle with respect to the third direction DR3 among the light emitted from the light emitting element layer EML. That is, the light control film 800 may control a viewing angle.

The light control film 800 may include a light transmitting louver 823 disposed in a light transmissive area LTA and a light blocking louver 822 disposed in an area other than the light transmissive area LTA. The light transmissive area LTA may overlap the sub-display area SDA in the third direction DR3. The light transmitting louver 823 may transmit light emitted from the light emitting element layer EML and the optical device 500. The light blocking louver 822 may absorb or block the light emitted from the light emitting element layer EML and the optical device 500.

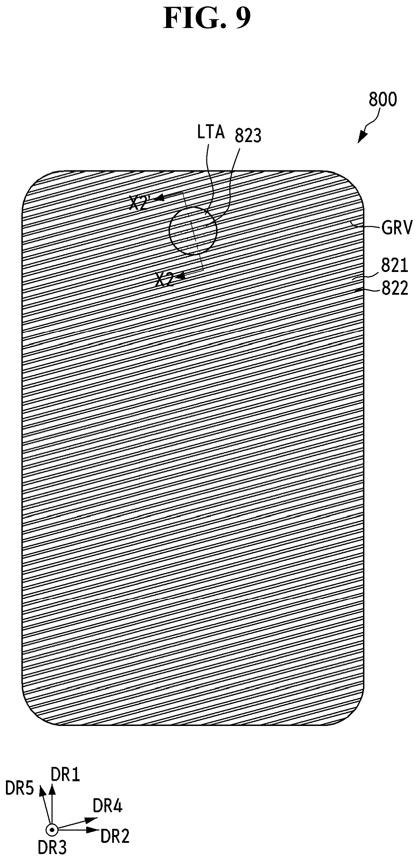

A detailed configuration of the light control film 800 will be described later with reference to FIG. 9, and other figures.

Although not illustrated in the drawing, the display device 10 may further include a cover window. The cover window may be additionally disposed on the light control film 800. In this case, the light control film 800 and the cover window may be attached by a transparent adhesive member such as a pressure sensitive adhesive film (PSA) or an optically clear adhesive film (OCA).

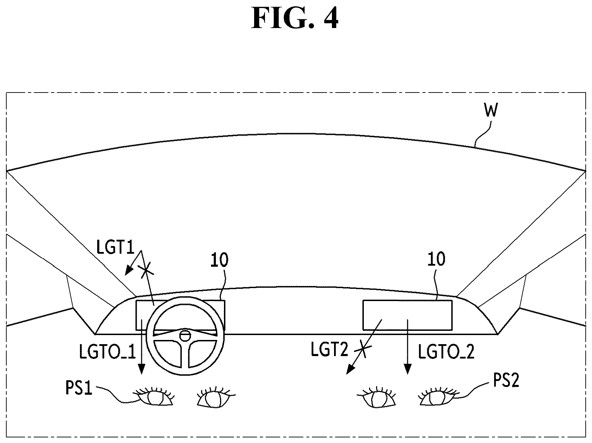

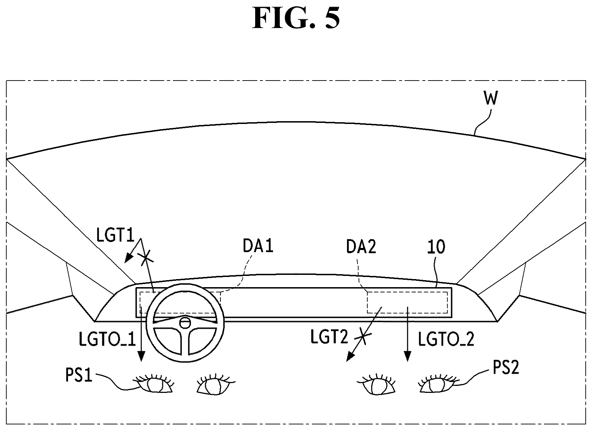

FIG. 4 is a schematic view illustrating an example of applying the display device according to an embodiment to an automobile. FIG. 5 is a schematic view illustrating another example of applying the display device according to an embodiment to an automobile.

Referring to FIGS. 4 and 5, the display device 10 according to an embodiment may be, for example, a display device applied to an automobile. The automobile may include a body forming an exterior of the automobile and an interior space defined by the body. The body may include a windshield W that protects a driver PS1 and a passenger PS2 from the outside and provides visibility to the driver PS1. As illustrated in the drawings, the display device 10 may be provided in the interior space.

In some embodiments, the display device 10 may be disposed on a dashboard provided in the interior space. As an example, as illustrated in FIG. 4, the display device 10 may be disposed on a dashboard in front of a driver's seat to provide speed information, or the like to the driver PS1, or may be disposed on a dashboard in front of a passenger seat to provide entertainment information, or the like to the passenger PS2, or may be disposed at the center of the dashboard to provide map information, or the like. FIG. 4 illustrates that the display device 10 is disposed on the dashboard in front of the driver's seat and in front of the passenger seat, respectively.

As another example, as illustrated in FIG. 5, the display device 10 may extend from the dashboard positioned in front of the driver's seat to the dashboard positioned in front of the passenger seat. For example, the display device 10 may be an integrated display connected from the dashboard positioned in front of the driver's seat to the dashboard positioned in front of the passenger seat. In this case, the display device 10 may include a first display area DA1 positioned in front of the driver's seat and a second display area DA2 positioned in front of the passenger seat. Although not illustrated in the drawing, the display device 10 may further include a third display area between the first display area DA1 and the second display area DA2.

Hereinafter, for convenience of explanation, the embodiment of FIG. 4 will be described as an example. However, the present disclosure is not limited to the embodiment of FIG. 4, and in the integrated display as in the embodiment of FIG. 5, the first display area DA1 and the second display area DA2 correspond to the display device 10 in front of the driver's seat and the display device 10 in front of the passenger seat, respectively, of FIG. 4, and the same technical idea may be applied thereto.

The driver PS1 may recognize (or visually recognize) a display screen of the display device 10 through light LGT0_1 emitted from the display device 10 towards the driver PS1. However, some LGT1 of the light emitted from the display device 10 in front of the driver's seat may be reflected on the surrounding windshield W and provided to the driver PS1. In this case, the image displayed on the windshield W may interfere with the driving of the driver PS1. In some embodiments, in the case of the display device 10 according to an embodiment, it is possible to prevent in advance that some LGT1 of the light emitted from the display device 10 in front of the driver's seat is reflected on the surrounding windshield W and provided to the driver PS1 by adjusting a viewing angle, especially a vertical viewing angle, with respect to a front direction (direction facing the driver PS1) of the light emitted from the display device 10.

The passenger PS2 may recognize (or visually recognize) a display screen of the display device 10 through light LGT0_2 emitted from the display device 10 in front of the passenger seat towards the passenger PS2. However, some LGT2 of the light emitted from the display device 10 in front of the passenger seat may be provided toward the driver PS1. In this case, when the automobile is driving, the viewing of the driver PS1 may be restricted for reasons such as safety. In the case of the display device 10 according to an embodiment, it is possible to prevent some LGT2 of the light emitted from the display device 10 in front of the passenger seat from being provided to the driver by adjusting the viewing angle, especially the left and right viewing angles, with respect to the front direction (direction facing the passenger PS2) of the light emitted from the display device 10.

It is illustrated in the drawing that the display device 10 in front of the driver's seat adjusts the vertical viewing angle, and the display device 10 in front of the passenger seat adjusts the left and right viewing angle, but embodiments of the present disclosure are not limited thereto. As an example, the display device 10 in front of the driver's seat may also adjust the right and left viewing angle, and the display device 10 in front of the passenger seat may also adjust the vertical viewing angle. As another example, the display device 10 in front of the driver's seat and the display device 10 in front of the passenger seat may also adjust both the vertical viewing angle and the left and right viewing angle, respectively.

The viewing angle may be adjusted through the light control film 800. The viewing angle may be limited to a selected angle range through the light control film 800. As an example, when an imaginary line facing the driver PS1 or passenger PS2 in the front direction and extending in a direction perpendicular to the display surface of the display device 10 is taken as a vertical line, the viewing angle may be an angle within 35° from the vertical line. In some embodiments, the angle within 35° from the vertical line may be defined as an effective viewing angle, but is not limited thereto.

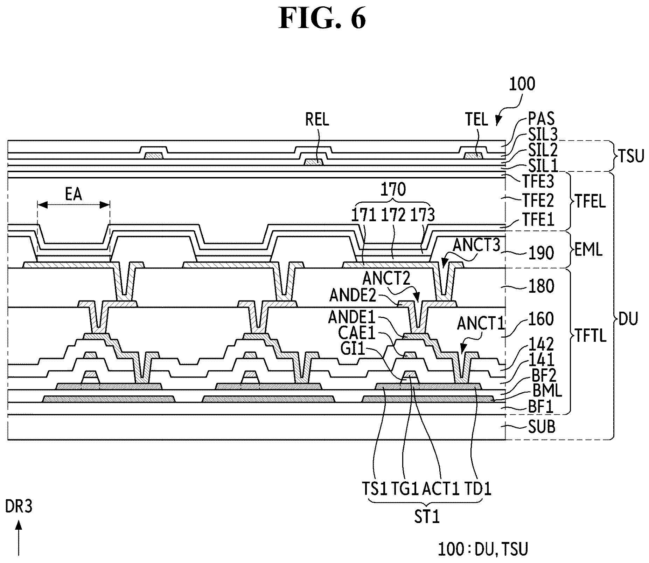

FIG. 6 is a cross-sectional view illustrating an example of a display panel according to an embodiment.

Referring to FIG. 6, the display panel 100 may include a display layer DU and a touch sensing layer TSU. The display layer DU may include a substrate SUB, a thin film transistor layer TFTL, a light emitting element layer EML, and an encapsulation layer TFEL.

The substrate SUB may include an insulating material such as glass, quartz, or a polymer resin. Examples of the polymer material may include polyethersulphone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (CAT), cellulose acetate propionate (CAP), or a combination thereof. Alternatively, the substrate may also include a metal material.

The substrate SUB may be a rigid substrate or a flexible substrate that may be bent, folded, and rolled. In an example in which the substrate is the flexible substrate, the substrate may include polyimide PI, but is not limited thereto.

The thin film transistor layer TFTL may include a first buffer film BF1, a lower metal layer BML, a second buffer film BF2, a first thin film transistor ST1, a first gate insulating film GI1, a first interlayer insulating film 141, a first capacitor electrode CAE1, a second interlayer insulating film 142, a first anode connection electrode ANDE1, a first organic film 160, a second anode connection electrode ANDE2, and a second organic film 180.

The first buffer film BF1 is a film for protecting the first thin film transistor ST1 and a light emitting layer 172 from moisture permeating through the substrate SUB, which is vulnerable to moisture permeation. The first buffer film BF1 may include a plurality of inorganic films alternately stacked. For example, the first buffer film BF1 may be formed as a multi-film in which one or more inorganic films of a silicon nitride layer, a silicon oxynitride layer, a silicon oxide layer, a titanium oxide layer, and an aluminum oxide layer are alternately stacked.

The lower metal layer BML may be disposed on the first buffer film BF1. The lower metal layer BML may be disposed to overlap a first active layer ACT1 of the first thin film transistor ST1 in the third direction DR3 to prevent leakage current from occurring when light is incident on the first active layer ACT1 of the first thin film transistor ST1. The lower metal layer BML may be formed as a single layer or a multi-layer including any one of molybdenum (Mo), aluminum (Al), chromium (Cr), gold (Au), titanium (Ti), nickel (Ni), neodymium (Nd), and copper (Cu), or an alloy thereof. The lower metal layer BML may be omitted.

The second buffer film BF2 may be disposed on the lower metal layer BML. The second buffer film BF2 is a film for protecting the first thin film transistor ST1 and the light emitting layer 172 from moisture permeating through the substrate SUB, which is vulnerable to moisture permeation. The second buffer film BF2 may include a plurality of inorganic films alternately stacked. For example, the second buffer film BF2 may be formed as a multi-film in which one or more inorganic films of a silicon nitride layer, a silicon oxynitride layer, a silicon oxide layer, a titanium oxide layer, and an aluminum oxide layer are alternately stacked.

The first active layer ACT1 of the first thin film transistor ST1 may be disposed on the second buffer film BF2. The first active layer ACT1 of the first thin film transistor ST1 includes polycrystalline silicon, single crystal silicon, low-temperature polycrystalline silicon, amorphous silicon, or an oxide semiconductor. The first active layer ACT1 of the first thin film transistor ST1 exposed and not covered by the first gate insulating film GI1 may be doped with impurities or ions to have conductivity. Therefore, a first source electrode TS1 and a first drain electrode TD1 of the first active layer ACT1 of the first thin film transistor ST1 may be formed.

The first gate insulating film GI1 may be disposed on the first active layer ACT1 of the first thin film transistor ST1. It is illustrated in FIG. 6 that the first gate insulating film GI1 is disposed between a first gate electrode TG1 and the first active layer ACT1 of the first thin film transistor ST1, but embodiments of the present disclosure are not limited thereto. The first gate insulating film GI1 may also be disposed between the first interlayer insulating film 141 and the first active layer ACT1 and between the first interlayer insulating film 141 and the second buffer film BF2. The first gate insulating film GI1 may be formed as an inorganic film, for example, a silicon nitride layer, a silicon oxynitride layer, a silicon oxide layer, a titanium oxide layer, or an aluminum oxide layer.

The first gate electrode TG1 of the first thin film transistor ST1 may be disposed on the first gate insulating film GI1. The first gate electrode TG1 of the first thin film transistor ST1 may overlap the first active layer ACT1 in the third direction DR3. The first gate electrode TG1 of the first thin film transistor ST1 may be formed as a single layer or a multi-layer including any one of molybdenum (Mo), aluminum (Al), chromium (Cr), gold (Au), titanium (Ti), nickel (Ni), neodymium (Nd), and copper (Cu), or an alloy thereof.

The first interlayer insulating film 141 may be disposed on the first gate electrode TG1 of the first thin film transistor ST1. The first interlayer insulating film 141 may be formed as an inorganic film, for example, a silicon nitride layer, a silicon oxynitride layer, a silicon oxide layer, a titanium oxide layer, or an aluminum oxide layer. The first interlayer insulating film 141 may include a plurality of inorganic films.

The first capacitor electrode CAE1 may be disposed on the first interlayer insulating film 141. The first capacitor electrode CAE1 may overlap the first gate electrode TG1 of the first thin film transistor ST1 in a third direction (Z-axis direction). Since the first interlayer insulating film 141 has a predetermined dielectric constant, a capacitor may be formed by the first capacitor electrode CAE1, the first gate electrode TG1, and the first interlayer insulating film 141 disposed between the first capacitor electrode CAE1 and the first gate electrode TG1. The first capacitor electrode CAE1 may be formed as a single layer or a multi-layer including any one of molybdenum (Mo), aluminum (Al), chromium (Cr), gold (Au), titanium (Ti), nickel (Ni), neodymium (Nd), and copper (Cu), or an alloy thereof.

The second interlayer insulating film 142 may be disposed on the first capacitor electrode CAE1. The second interlayer insulating film 142 may be formed as an inorganic film, for example, a silicon nitride layer, a silicon oxynitride layer, a silicon oxide layer, a titanium oxide layer, or an aluminum oxide layer. The second interlayer insulating film 142 may include a plurality of inorganic films.

The first anode connection electrode ANDE1 may be disposed on the second interlayer insulating film 142. The first anode connection electrode ANDE1 may be connected to the first drain electrode TD1 of the first thin film transistor ST1 through a first anode contact hole ANCT1 penetrating through the first interlayer insulating film 141 and the second interlayer insulating film 142 to expose the first drain electrode TD1 of the first thin film transistor ST1. The first anode connection electrode ANDE1 may be formed as a single layer or a multi-layer including any one of molybdenum (Mo), aluminum (Al), chromium (Cr), gold (Au), titanium (Ti), nickel (Ni), neodymium (Nd), and copper (Cu), or an alloy thereof.

The first organic film 160 for planarization may be disposed on the first pixel connection electrode ANDE1. The first organic film 160 may be formed as an organic film including an acryl resin, an epoxy resin, a phenolic resin, a polyamide resin, a polyimide resin, or the like.

The second anode connection electrode ANDE2 may be disposed on the first organic film 160. The second anode connection electrode ANDE2 may be connected to the first anode connection electrode ANDE1 through a second anode contact hole ANCT2 penetrating through the first organic film 160 to expose the first anode connection electrode ANDE1. The second anode connection electrode ANDE2 may be formed as a single layer or a multi-layer including any one of molybdenum (Mo), aluminum (Al), chromium (Cr), gold (Au), titanium (Ti), nickel (Ni), neodymium (Nd), and copper (Cu), or an alloy thereof.

The second organic film 180 may be disposed on the second anode connection electrode ANDE2. The second organic film 180 may be formed as an organic film including an acryl resin, an epoxy resin, a phenolic resin, a polyamide resin, a polyimide resin, or the like.

It is illustrated in FIG. 6 that the first thin film transistor ST1 is formed in a top gate type in which the first gate electrode TG1 is positioned above the first active layer ACT1, but embodiments of the present disclosure are not limited thereto. The first thin film transistor ST1 may be formed in a bottom gate type in which the first gate electrode TG1 is positioned below the first active layer ACT1 or a double gate type in which the first gate electrode TG1 is positioned both above and below the first active layer ACT1.

The light emitting element layer EML may be disposed on the second organic film 180. The light emitting element layer EML may include light emitting elements 170 and a bank 190. Each of the light emitting elements 170 may include a first light emitting electrode 171, a light emitting layer 172, and a second light emitting electrode 173.

The first light emitting electrode 171 may be formed on the second organic film 180. The first light emitting electrode 171 may be connected to the second anode connection electrode ANDE2 through a third anode contact hole ANCT3 penetrating through the second organic film 180 to expose the second anode connection electrode ANDE2.

The first light emitting electrode 171 may be formed on the second organic film 180. The first light emitting electrode 171 may be connected to the second anode connection electrode ANDE2 through a third anode contact hole ANCT3 penetrating through the second organic film 180 to expose the second anode connection electrode ANDE2.

In a top emission structure in which light is emitted toward the second light emitting electrode 173 based on the light emitting layer 172, the first light emitting electrode 171 may include a metal material having high reflectance, such as a stacked structure (Ti/Al/Ti) of aluminum and titanium, a stacked structure (ITO/Al/ITO) of aluminum and indium tin oxide (ITO), an APC alloy, and a stacked structure (ITO/APC/ITO) of an APC alloy and ITO. The APC alloy is an alloy of silver (Ag), palladium (Pd), and copper (Cu).

The bank 190 may be formed to partition the first light emitting electrode 171 on the second organic film 180 to define a light emitting area EA. The bank 190 may include an opening that exposes at least a portion of an upper surface of the first light emitting electrode 171. The bank 190 may be formed such that the bank 190 covers an edge of the first light emitting electrode 171. The bank 190 may be formed as an organic film including an acrylic resin, an epoxy resin, a phenolic resin, a polyamide resin, or a polyimide resin.

The light emitting area EA refers to an area in which the first light emitting electrode 171, the light emitting layer 172, and the second light emitting electrode 173 are sequentially stacked and holes from the first light emitting electrode 171 and electrons from the second light emitting electrode 173 are bonded to each other in the light emitting layer 172 to emit light. The light emitting area EA may be defined by the opening of the bank 190.

The light emitting layer 172 is formed on the first light emitting electrode 171 and the bank 190. The light emitting layer 172 may be disposed within the opening of the bank 190, but is not limited thereto. The light emitting layer 172 may include an organic material to emit light of a selected color. For example, the light emitting layer 172 may include a hole transporting layer, an organic material layer, and an electron transporting layer.

The second light emitting electrode 173 may be disposed on the light emitting layer 172. The second light emitting electrode 173 may be formed such that the electrode 173 covers the light emitting layer 172. The second light emitting electrode 173 may be a common layer commonly formed in all the light emitting areas EA. Although not illustrated, in some embodiments, a capping layer may be formed on the second light emitting electrode 173.

In the top emission structure, the second light emitting electrode 173 may include transparent conductive oxide (TCO) such as indium tin oxide (ITO) or indium zinc oxide (IZO) capable of transmitting light, or a semi-transmissive conductive material such as magnesium (Mg), silver (Ag), or an alloy of magnesium (Mg) and silver (Ag). In an example in which the second light emitting electrode 173 includes the semi-transmissive conductive material, light emission efficiency may be increased by a micro cavity.

The encapsulation layer TFEL may be disposed on the second light emitting electrode 173. The encapsulation layer TFEL may include at least one inorganic film to prevent oxygen or moisture from permeating into the light emitting element layer. In some aspects, the encapsulation layer TFEL may include at least one organic film to protect the light emitting element layer from foreign substances such as dust. For example, the encapsulation layer TFEL may include a first encapsulation film TFE1, a second encapsulation film TFE2, and a third encapsulation film TFE3.

The first encapsulation film TFE1 (e.g., a first inorganic encapsulation film) may be disposed on the second light emitting electrode 173. The first encapsulation film TFE1 may be an inorganic film of a single layer or a multi-layer. The first encapsulation film TFE1 may be formed as a single film or a multi-film in which one or more inorganic films of a silicon nitride layer, a silicon oxynitride layer, a silicon oxide layer, a titanium oxide layer, and an aluminum oxide layer are alternately stacked.

The second encapsulation film TFE2 (e.g., a first organic encapsulation film) may be disposed on the first encapsulation film TFE1. The second encapsulation film TFE2 may be an organic film of a single layer or a multi-layer. The second encapsulation film TFE2 may include a polymer-based material. Examples of the polymer-based material may include polyethylene terephthalate, polyethylene naphthalate, polycarbonate, polyimide, polyethylene sulfonate, polyoxymethylene, polyarylate, hexamethyldisiloxane, acrylic resin (e.g., polymethyl methacrylate, polyacrylic acid, or the like), or any combination thereof.

The third encapsulation film TFE3 (e.g., a second inorganic encapsulation film) may be disposed on the second encapsulation film TFE2. The third encapsulation film TFE3 may be an inorganic film of a single layer or a multi-layer. The third encapsulation film TFE3 may include the same material as the first encapsulation film TFE1. For example, the third encapsulation film TFE3 may be formed as a single film or a multi-film in which one or more inorganic films of a silicon nitride layer, a silicon oxynitride layer, a silicon oxide layer, a titanium oxide layer, and an aluminum oxide layer are alternately stacked.

The touch sensing layer TSU may be disposed on the encapsulation layer TFEL. The touch sensing layer TSU may include a plurality of touch electrodes for sensing a user's touch in a capacitance method, and touch lines connecting the plurality of touch electrodes and the touch driver. For example, the touch sensing layer TSU may sense the user's touch in a mutual capacitance method or a self-capacitance method.

In another embodiment, the touch sensing layer TSU may be disposed on a separate substrate disposed on the display layer DU. In this case, the substrate supporting the touch sensing layer TSU may be an encapsulation member that encapsulates the display layer DU.

The plurality of touch electrodes of the touch sensing layer TSU may be disposed in a touch sensor area overlapping the display area. The touch lines of the touch sensing layer TSU may be disposed in a touch peripheral area overlapping the non-display area.

The touch sensing layer TSU may include a first touch insulating film SIL1, a first touch electrode REL, a second touch insulating film SIL2, a second touch electrode TEL, and a third touch insulating film SIL3.

The first touch insulating film SIL1 may be disposed on the encapsulation layer TFEL. The first touch insulating film SIL1 may have insulation and optical functions. The first touch insulating film SIL1 may include at least one inorganic film. For example, the first touch insulating film SIL1 may be an inorganic film including at least one of a silicon nitride layer, a silicon oxynitride layer, a silicon oxide layer, a titanium oxide layer, and an aluminum oxide layer. Optionally, the first touch insulating film SIL1 may be omitted.

The first touch electrode REL may be disposed on the first touch insulating film SIL1. The first touch electrode REL may not overlap the light emitting element 170. The first touch electrode REL may be formed as a single layer including molybdenum (Mo), titanium (Ti), copper (Cu), aluminum (Al), or indium tin oxide (ITO), or be formed as a stacked structure (Ti/Al/Ti) of aluminum and titanium, a stacked structure (ITO/Al/ITO) of aluminum and ITO, an APC alloy, and a stacked structure (ITO/APC/ITO) of an APC alloy and ITO.

The second touch insulating film SIL2 may cover the first touch electrode REL and the first touch insulating film SIL1. The second touch insulating film SIL2 may have insulation and optical functions. For example, the second touch insulating film SIL2 may be formed of the materials illustrated in the first touch insulating film SIL1.

The second touch electrode TEL may be disposed on the second touch insulating film SIL2. The second touch electrode TEL may not overlap the light emitting element 170. The second touch electrode TEL may be formed as a single layer including molybdenum (Mo), titanium (Ti), copper (Cu), aluminum (Al), or indium tin oxide (ITO), or be formed as a stacked structure (Ti/Al/Ti) of aluminum and titanium, a stacked structure (ITO/Al/ITO) of aluminum and ITO, an APC alloy, and a stacked structure (ITO/APC/ITO) of an APC alloy and ITO.

The third touch insulating film SIL3 may cover the second touch electrode TEL and the second touch insulating film SIL2. The third touch insulating film SIL3 may have insulation and optical functions. The third touch insulating film SIL3 may be formed of the materials illustrated in the second touch insulating film SIL2.

In some embodiments, the first touch insulating film SIL1, the second touch insulating film SIL2, and the third touch insulating film SIL3 may be organic films. For example, the first touch insulating film SIL1, the second touch insulating film SIL2, and the third touch insulating film SIL3 may be organic films including an acryl resin, an epoxy resin, a phenolic resin, a polyamide resin, a polyimide resin, or the like.

The touch sensing layer TSU may further include a planarization film PAS for planarization. The planarization film PAS may be formed as an organic film including an acrylic resin, an epoxy resin, a phenolic resin, a polyamide resin, a polyimide resin, or the like.

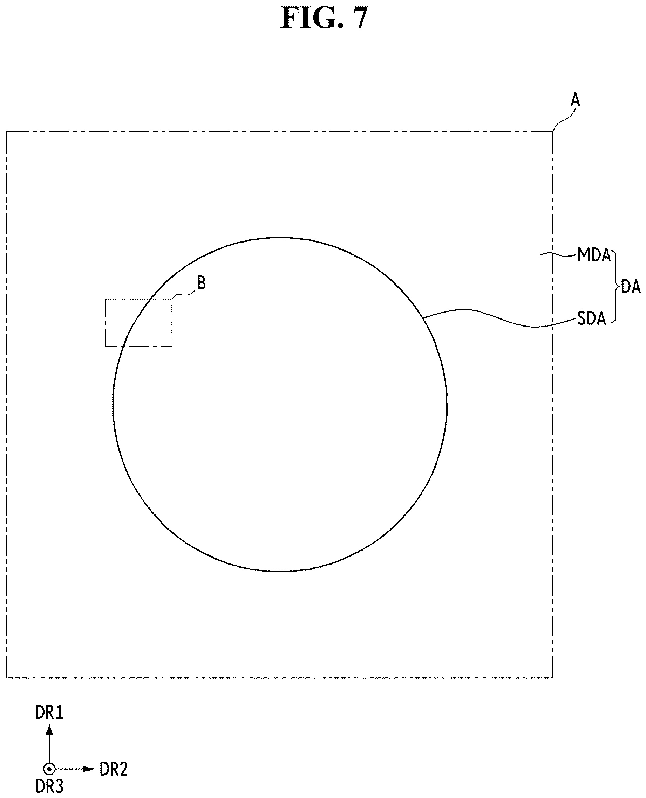

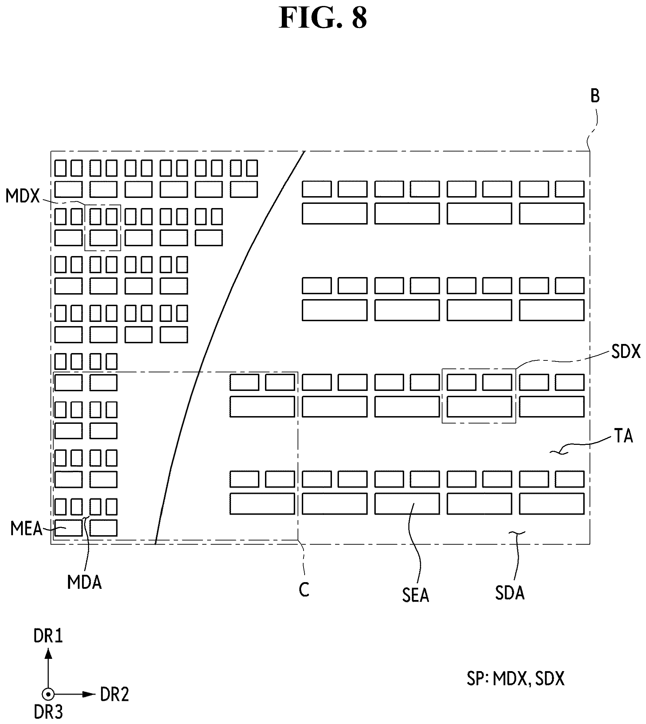

FIG. 7 is an enlarged view of area A of FIG. 2. FIG. 8 is an enlarged view of area B of FIG. 7.

Referring to FIGS. 7 and 8 in addition to FIGS. 3 and 6, the display area DA may include a main display area MDA and a sub-display area SDA. The sub-display area SDA may be an area where the optical device 500 is disposed below the substrate SUB of the display device 10.

A pixel SP may include main display pixels MDX disposed in the main display area MDA and sub-display pixels SDX disposed in the sub-display area SDA. That is, a plurality of main display pixels MDX can be disposed in the main display area MDA, and a plurality of sub-display pixels SDX may be disposed in the sub-display area SDA. Each of the main display pixels MDX may include one or more main light emitting areas MEA, and each of the sub-display pixels SDX may include one or more sub-light emitting areas SEA. The light emitting element 170 is disposed in each of the light emitting areas MEA and SEA such that light may be emitted.

In the main display area MDA, a plurality of light emitting elements 170 that emit light, and pixel circuits that are electrically connected to the light emitting elements 170 and apply signals for emitting light to the light emitting elements 170 may be disposed. The main display area MDA may be an area where the light emitting elements 170 and the pixel circuits are arranged in a specific arrangement. In the main display area MDA, each of the light emitting elements 170 may constitute the main light emitting area MEA, and a plurality of main light emitting areas MEA may constitute one main display pixel MDX. For example, as illustrated in FIG. 8, three main light emitting areas MEA may constitute one main display pixel MDX. That is, one main display pixel MDX may include three main light emitting areas MEA, and the three main light emitting areas MEA may constitute one main display pixel MDX to express white gradation. However, the number of main light emitting areas MEA included in the main display pixel MDX is not limited thereto.

In some embodiments, the plurality of main display pixels MDX disposed in the main display area MDA may be arranged in the first direction DR1 and/or the second direction DR2. In some aspects, the plurality of main light emitting areas MEA of the main display pixels MDX may be arranged in the first direction DR1 and/or the second direction DR2. For example, a first main light emitting area MEA and a second main light emitting area MEA may be spaced apart from a third main light emitting area MEA in the first direction DR1, and may be spaced apart from each other in the second direction DR2. However, the arrangement of the plurality of main display pixels MDX and the arrangement of the plurality of main light emitting areas MEA may be variously modified, without being limited to what is illustrated in the drawing.

The light emitting elements 170 that emit light are also disposed in the sub-display area SDA to constitute the sub-light emitting area SEA, and a plurality of sub-light emitting areas SEA may constitute one sub-display pixel SDX. However, the sub-display area SDA, which is a component disposed on a back surface of the substrate SUB of the display panel 100, may be, for example, an area overlapping the optical device 500, and may have a structure in which light transmittance is taken into consideration, unlike the main display area MDA.

The sub-display pixel SDX constituted by the plurality of sub-light emitting areas SEA of the sub-display area SDA may have a different arrangement from the main display pixel MDX. For example, the size and shape of the plurality of sub-light emitting areas SEA included in the sub-display pixel SDX may be different from the size and shape of the main-light emitting area MEA included in the main display pixel MDX.

In some aspects, since the sub-display area SDA includes a transmissive area TA described later, a density of the sub-display pixels SDX in the sub-display area SDA may be lower than a density of the main display pixels MDX in the main display area MDA. Accordingly, the sub-display area SDA may have differences in luminance and resolution compared to the main display area MDA.

In some embodiments, the plurality of sub-display pixels SDX disposed in the sub-display area SDA may be arranged in the first direction DR1 and/or the second direction DR2. In some aspects, the plurality of sub-light emitting areas SEA of the sub-display pixels SDX may be arranged in the first direction DR1 and/or the second direction DR2. For example, a first sub-light emitting area SEA and a second sub-light emitting area SEA may be spaced apart from a third sub-light emitting area SEA in the first direction DR1, and may be spaced apart from each other in the second direction DR2. However, the arrangement of the plurality of sub-display pixels SDX and the arrangement of the plurality of sub-light emitting areas SEA may be variously modified, without being limited to what is illustrated in the drawing.

The sub-display area SDA may further include transmissive areas TA that transmit light. The transmissive area TA is an area that passes light incident on the display panel 100. For example, the transmissive area TA may be an area where a conductive layer of the circuit layer TFTL, a light emitting element of the light emitting element layer EML, and conductive layers of the touch sensing layer TSU are not disposed.

The transmissive area TA may be disposed adjacent to the sub-light emitting areas SEA. The transmissive area TA may not overlap the sub-light emitting areas SEA. The transmissive area TA may surround the sub-light emitting areas SEA.

Due to the transmissive areas TA, the number of sub-light emitting areas SEA per unit area in the sub-display area SDA may be different from the number of main light emitting areas MEA per unit area in the main display area MDA. For example, the number of sub-light emitting areas SEA per unit area in the sub-display area SDA may be smaller than the number of main light emitting areas MEA per unit area in the main display area MDA.

In some aspects, due to the transmissive areas TA, a ratio of an area of the sub-light emitting areas SEA to an area of the sub-display area SDA may be different from a ratio of an area of the main light emitting areas MEA to an area of the main display area MDA. For example, the ratio of the area of the sub-light emitting areas SEA to the area of the sub-display area SDA may be smaller than the ratio of the area of the main light emitting areas MEA to the area of the main display area MDA.

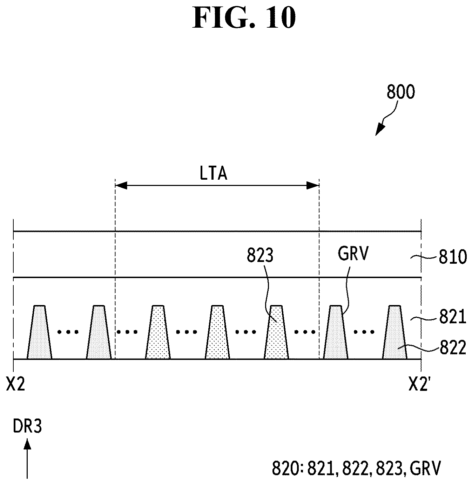

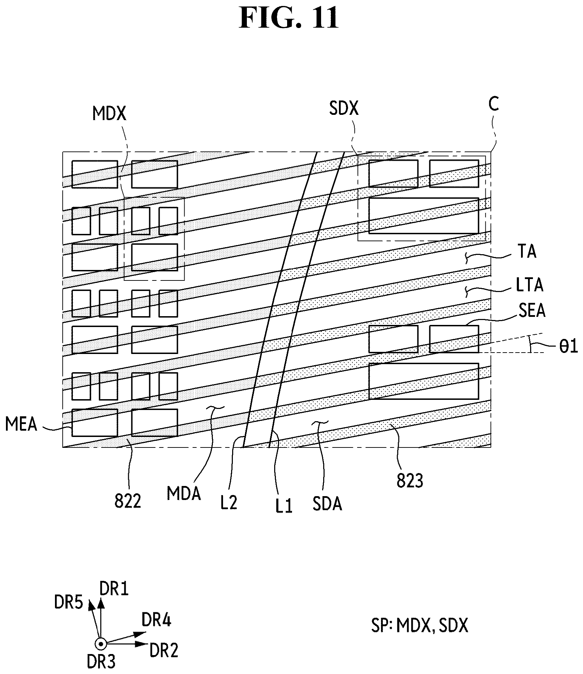

FIG. 9 is a plan view illustrating a light control film according to an embodiment. FIG. 10 is a cross-sectional view taken along line X3-X3' of FIG. 9. FIG. 11 is an enlarged view of area C of FIG. 8.

Referring to FIGS. 9 to 11 in addition to FIGS. 6 to 8, the light control film 800 may include a base film 810 and a light control layer 820.

The base film 810 may support the light control layer 820. For example, the base film 810 may provide a space in which the light control layer 820 may be formed when manufacturing the light control film 800.

In some embodiments, the base film 810 may include at least one of polyethylene terephthalate (PET), polycarbonate (PC), and tri-acetyl cellulose (TAC), but is not limited thereto.

The light control layer 820 may include a light transmissive layer 821, a light blocking louver 822, and a light transmitting louver 823.

The light transmissive layer 821 may be disposed on the base film 810. The light transmissive layer 821 may be disposed below the base film 810. The light transmissive layer 821 may transmit the light emitted from the light emitting layer 172.

The light transmissive layer 821 may include a transparent organic material. For example, the light transmissive layer 821 may include an organic film including an acryl resin, an epoxy resin, a phenolic resin, a polyamide resin, a polyimide resin, or the like. In another embodiment, the light transmissive layer 821 may also include an inorganic material such as silicon oxynitride or silicon oxide.

The light transmissive layer 821 may include a groove GRV. The groove GRV may be a groove formed concavely from a lower surface to an upper surface of the light transmissive layer 821. In some embodiments, an upper surface of the groove GRV may be spaced apart from an interface between the base film 810 and the light transmissive layer 821 in the third direction DR3. That is, a thickness of the groove GRV in the third direction DR3 may be smaller than a thickness of the light transmissive layer 821 in the third direction DR3.

In some embodiments, the groove GRV may have a shape of which width becomes narrower from the bottom to the top. For example, the groove GRV may have a shape of which width becomes narrower in the third direction DR3. That is, the width of the groove GRV may become narrower as the groove GRV approaches the base film 810. However, the width of the groove GRV is not limited thereto, and may be constant along the third direction DR3.

The groove GRV may extend in one direction, and a plurality of grooves GRV may be spaced apart from each other in a different direction from the extending direction. For example, as illustrated in FIG. 9, the groove GRV may extend in a fourth direction DR4, and the plurality of grooves GRV may be spaced apart from each other in a fifth direction DR5. However, embodiments of the present disclosure are not limited thereto, and the groove GRV may extend in the first direction DR1 or the second direction DR2, and the plurality of grooves GRV may be spaced apart from each other in the second direction DR2 or the first direction DR1.

The fourth direction DR4 may be a diagonal direction defined by the first direction DR1 and the second direction DR2. The fifth direction DR5 may be a diagonal direction defined by opposite directions of the first direction DR1 and the second direction DR2. The fourth direction DR4 and the fifth direction DR5 may be different directions from the first direction DR1, the second direction DR2, and the third direction DR3. The fourth direction DR4 and the fifth direction DR5 may be positioned on the same plane as the first direction DR1 and the second direction DR2. The fourth direction DR4 and the fifth direction DR5 may be perpendicular to each other, but are not limited thereto.

For example, as illustrated in FIG. 11, an angle formed by the fourth direction DR4 and the second direction DR2 may be a first angle θ1. The first angle θ1 may be approximately 0 degrees or more and less than 30 degrees, and preferably, the first angle θ1 may be approximately 7 degrees, but is not limited thereto.

The light transmissive layer 821 may be formed by applying a transparent liquid resin on the base film 810, forming a groove GRV using a roller or a jig, and then curing the resin while maintaining the shape of the groove GRV.

The light blocking louver 822 may be disposed within the groove GRV of the light transmissive layer 821. The light blocking louver 822 may absorb or block the light emitted from the light emitting layer 172. The light blocking louver 822 may include a light blocking organic material. For example, the light blocking louver 822 may include an organic material including an organic black pigment such as carbon black, as a photosensitive resin capable of absorbing or blocking light. The light blocking louver 822 may be formed by applying black pigment and liquid resin to the groove GRV and then curing the black pigment and the liquid resin.

In some embodiments, the light blocking louver 822 may have a shape of which width becomes narrower from the bottom to the top. For example, the light blocking louver 822 may have a shape of which width becomes narrower in the third direction DR3. That is, the width of the light blocking louver 822 may become narrower as the light blocking louver 822 approaches the base film 810. However, the width of the light blocking louver 822 is not limited thereto, and may be constant along the third direction DR3.

In some embodiments, an upper surface of the light blocking louver 822 may be spaced apart from an interface between the base film 810 and the light transmissive layer 821 in the third direction DR3. That is, a thickness of the light blocking louver 822 in the third direction DR3 may be smaller than the thickness of the light transmissive layer 821 in the third direction DR3.

The light transmitting louver 823 may be disposed within the groove GRV of the light transmissive layer 821. The light transmitting louver 823 may transmit the light emitted from the light emitting layer 172.

The light transmitting louver 823 may include a transparent organic material. For example, the light transmitting louver 823 may include an organic film including an acryl resin, an epoxy resin, a phenolic resin, a polyamide resin, a polyimide resin, or the like. In another embodiment, the light transmissive layer 821 may also include an inorganic material such as silicon oxynitride or silicon oxide.

The light transmitting louver 823 may be formed by applying a transparent liquid resin to the groove GRV and then curing the transparent liquid resin.

The light transmitting louver 823 may include a material different from or the same as the light transmissive layer 821. In an example in which the light transmitting louver 823 and the light transmissive layer 821 include different respective materials, an interface between the light transmitting louver 823 and the light transmissive layer 821 may be visually recognizable due to differences in physical properties such as refractive index. In an example in which the light transmitting louver 823 and the light transmissive layer 821 include the same material, the interface between the light transmitting louver 823 and the light transmissive layer 821 may be visually recognizable due to the difference in particle arrangement, because the light transmissive layer 821 is cured first and then the light transmitting louver 823 is cured.

In some embodiments, the light transmitting louver 823 may have a shape of which width becomes narrower from the bottom to the top. For example, the light transmitting louver 823 may have a shape of which width becomes narrower in the third direction DR3. That is, the width of the light transmitting louver 823 may become narrower as the light transmitting louver 823 approaches the base film 810. However, the width of the light transmitting louver 823 is not limited thereto, and may be constant along the third direction DR3.

In some embodiments, an upper surface of the light transmitting louver 823 may be spaced apart from an interface between the base film 810 and the light transmissive layer 821 in the third direction DR3. That is, a thickness of the light transmitting louver 823 in the third direction DR3 may be smaller than the thickness of the light transmissive layer 821 in the third direction DR3.

The light control film 800 may include a light transmissive area LTA. The light transmissive area LTA may overlap the sub-display area SDA of the display panel 100 in the third direction DR3. The shape of the light transmissive area LTA may correspond to the sub-display area SDA of the display panel 100. The light transmitting louver 823 may be disposed in the light transmissive area LTA, and the light blocking louver 822 may be disposed in an area other than the light transmissive area LTA.

For example, the light blocking louver 822 may extend in the fourth direction DR4 in the area other than the light transmissive area LTA, and the light transmitting louver 823 may extend in the fourth direction DR4 within the light transmissive area LTA. Therefore, as illustrated in FIG. 9, in the grooves GRV among the plurality of grooves GRV that cross the light transmissive area LTA in the fourth direction DR4, the light blocking louver 822 may be disposed in a portion of each groove GRV (a portion that does not overlap the light transmissive area LTA), and the light transmitting louver 823 may be disposed on another portion (a portion that overlaps the light transmissive area LTA).

As illustrated in FIG. 11, since the light transmissive area LTA overlaps the sub-display area SDA, the light blocking louver 822 may overlap the main light emitting areas MEA of the main display pixels MDX in the third direction DR3, and the light transmitting louver 823 may overlap the sub-light emitting areas SEA of the sub-display pixels SDX in the third direction DR3.

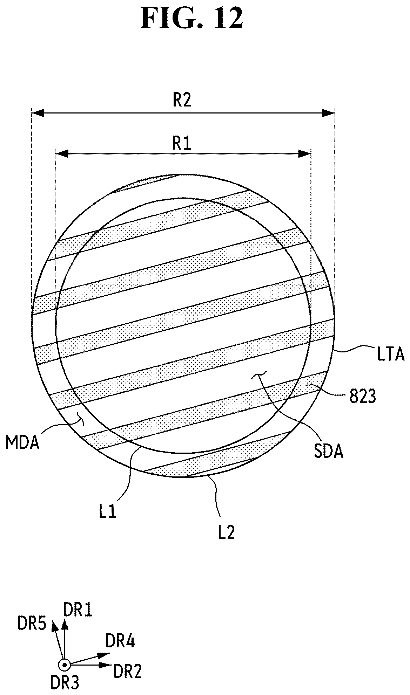

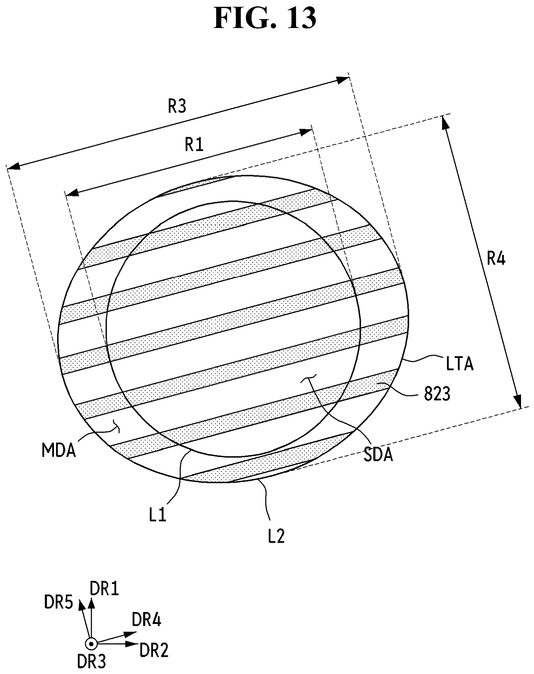

FIG. 12 is a plan view illustrating an example of a display area and a light transmissive area of a display device according to an embodiment. FIG. 13 is a plan view illustrating another example of a display area and a light transmissive area of a display device according to an embodiment.

Referring to FIGS. 12 and 13 in addition to FIG. 11, a second boundary line L2 that separates the light transmissive area LTA and the area other than the light transmissive area LTA may be positioned outside a first boundary line L1 that separates the main display area MDA and the sub-display area SDA. That is, a perimeter of the second boundary line L2 may be positioned outside a perimeter of the first boundary line L1, and the second boundary line L2 may surround the first boundary line L1.

The first boundary line L1 is an imaginary line that separates the main display area MDA and the sub-display area SDA, and the second boundary line L2 is an imaginary line that separates the light transmissive area LTA and the area other than the light transmissive area LTA. For example, the first boundary line L1 may be an imaginary line that separates the main light emitting area MEA and the sub-light emitting area SEA without overlapping the main light emitting area MEA and the sub-light emitting area SEA in the third direction DR3, as illustrated in FIG. 11. The second boundary line L2 may be an imaginary line generated by connecting boundary points (boundary surfaces) of the light blocking louver 822 and the light transmitting louver 823.

In some embodiments, as illustrated in FIG. 12, the sub-display area SDA and the light transmissive area LTA may be circular in a plan view. A width (or diameter) R1 of the sub-display area SDA defined by the first boundary line L1 may be smaller than a width (or diameter) R2 of the light transmissive area LTA defined by the second boundary line L2.

In another embodiment, as illustrated in FIG. 13, the sub-display area SDA may be circular in a plan view, and the light transmissive area LTA may be elliptical in the plan view. For example, the light transmissive area LTA may have a major axis extending in the fourth direction DR4 and a minor axis extending in the fifth direction DR5. A diameter R3 of the major axis of the light transmissive area LTA may be greater than a diameter R4 of the minor axis of the light transmissive area LTA. The diameter R3 of the major axis and the diameter R4 of the minor axis of the light transmissive area LTA may be greater than the width (or diameter) R1 of the sub-display area SDA.

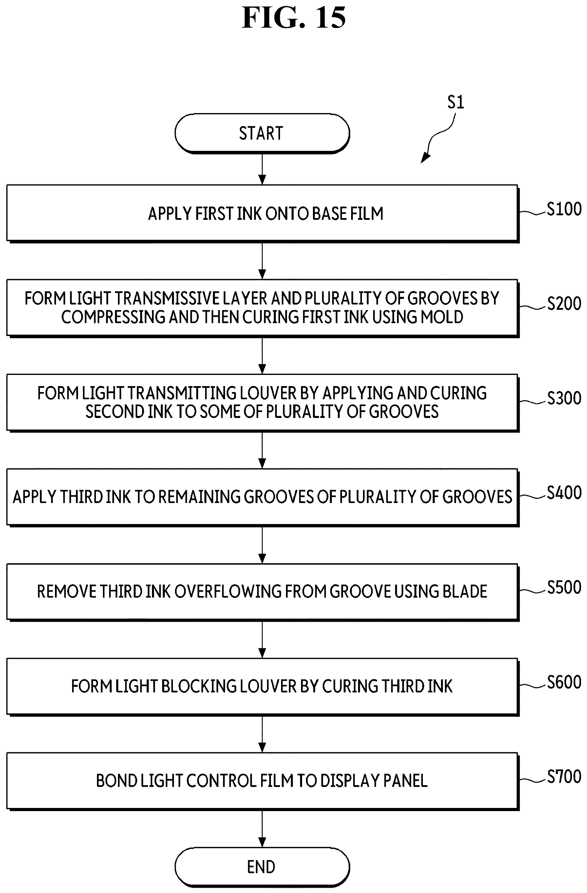

According to a method S1 for manufacturing the display device described later (see FIG. 15), the light transmitting louver 823 may be formed by applying a liquid resin to the groove GRV. Since the groove GRV has a narrow width in the fifth direction DR5 but extends long in the fourth direction DR4, the light transmitting louver 823 may be formed longer in the fourth direction DR4 due to surface tension and capillary phenomenon. Therefore, the diameter R3 of the major axis of the light transmissive area LTA may be formed to be greater than the diameter R4 of the minor axis of the light transmissive area LTA.

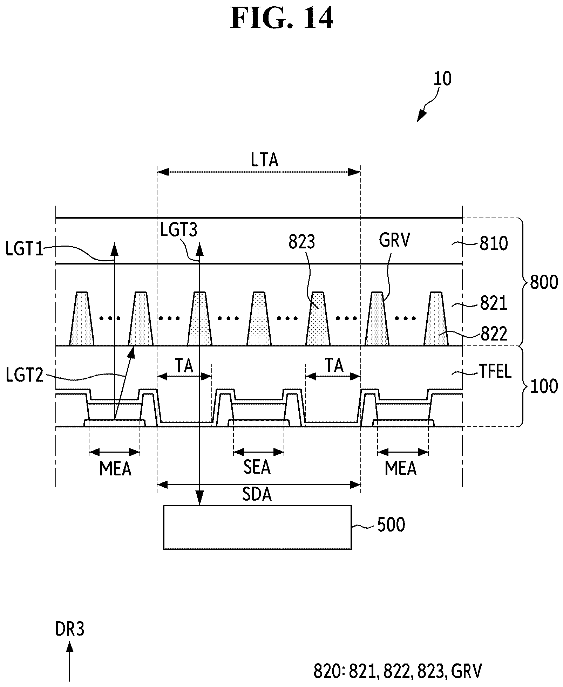

FIG. 14 is a cross-sectional view for describing an operation of the display device according to an embodiment.

Referring to FIG. 14, the light control film 800 may be disposed on the display panel 100. It is illustrated in FIG. 14 that the light control film 800 is directly disposed on the display panel 100, but embodiments of the present disclosure are not limited thereto. For example, as illustrated in FIG. 3, a polarizing film 700 may also be interposed between the light control film 800 and the display panel 100.

The light control layer 820 of the light control film 800 may control a viewing angle of light emitted from the main light emitting area MEA. For example, the first light LGT1 emitted from the main light emitting area MEA and traveling at a selected angle or less with respect to the third direction DR3 may be emitted to the outside through the light transmissive layer 821. The second light LGT2 emitted from the main light emitting area MEA and traveling beyond a selected angle with respect to the third direction DR3 may be absorbed or blocked by the light blocking louver 822 and may not be emitted to the outside.

The display device 10 according to the present embodiment may improve a sensing accuracy of the optical device 500 by including the light transmissive area LTA overlapping the sub-display area SDA.

For example, the optical device 500 may emit third light LGT3 to sense an object. The third light LGT3 emitted from the optical device 500 may pass through the transmissive area TA of the sub-display area SDA and be emitted to the outside through the light transmissive layer 821 and the light transmitting louver 823. Similarly, the third light LGT3 reflected by the object may pass through the light transmissive layer 821 and the light transmitting louver 823 again and be incident on the optical device 500 through the transmissive area TA.

In an embodiment, a light transmittance of the transmissive area TA of the sub-display area SDA may be approximately 20% to 40%. In a comparative example, when the light control film 800 does not include the light transmissive area LTA and the light transmitting louver 823, and the light blocking louver 822 is disposed in an area overlapping the sub-display area SDA, the light transmittance of light emitted through the transmissive area TA and the light control film 800 may be less than approximately 20%. In contrast, for example, in the display device 10 according to the present embodiment, as the light control film 800 includes the light transmissive area LTA and the light transmitting louver 823, the light transmittance of light emitted through the transmissive area TA and the light control film 800 may be 95% or more of the light transmittance of the transmissive area TA of the sub-display area SDA. That is, in the display device 10 according to the present embodiment, the light transmittance of light emitted through the transmissive area TA and the light control film 800 may be approximately 19% to 40%. Here, the light transmittance may mean a transmittance for light with a wavelength of approximately 100 nm to 1500 nm.

Hereinafter, a method for manufacturing a display device according to an embodiment will be described.

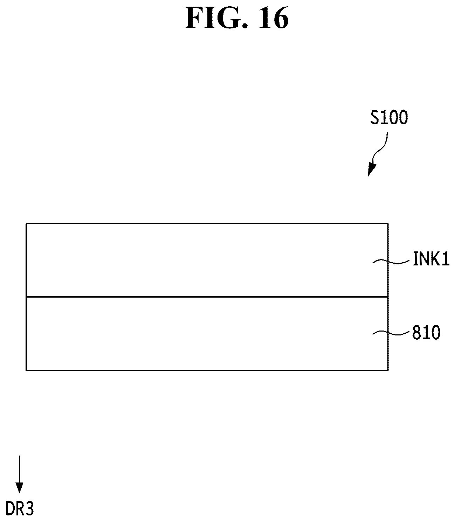

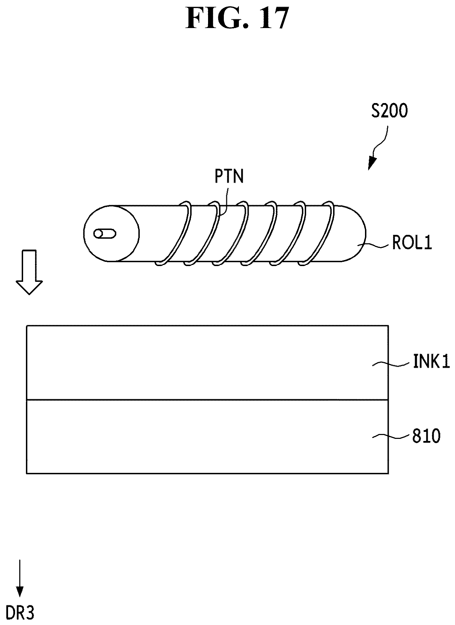

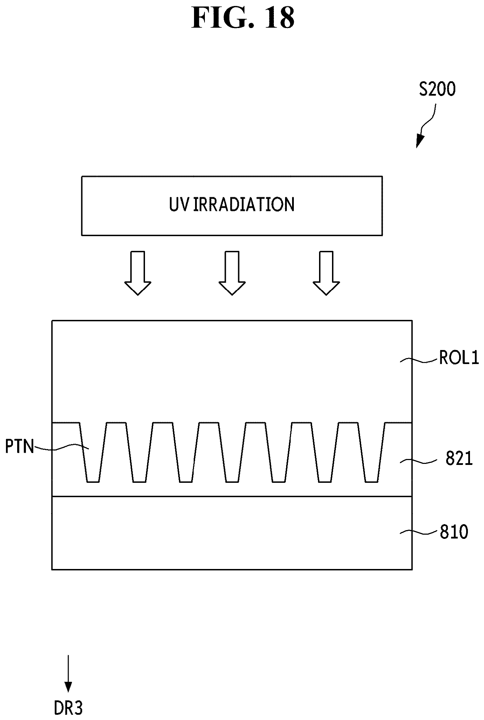

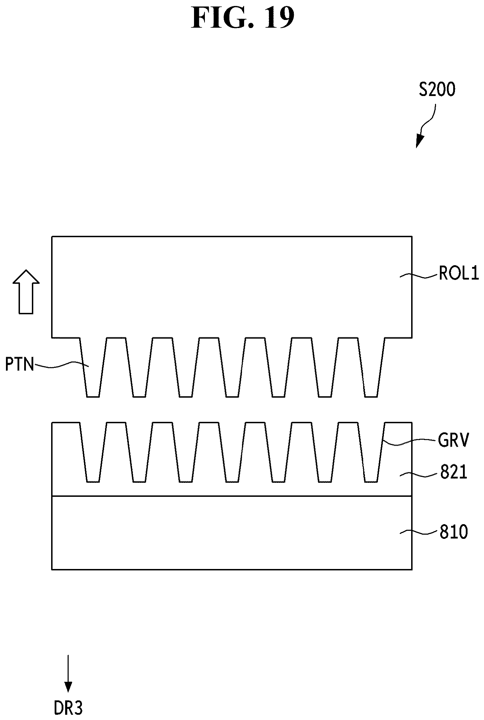

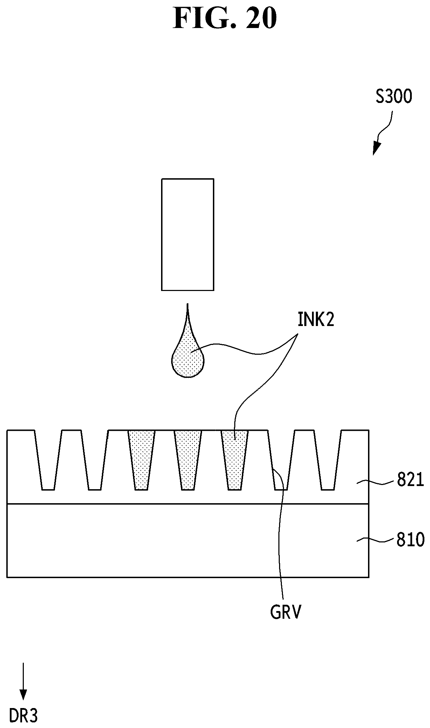

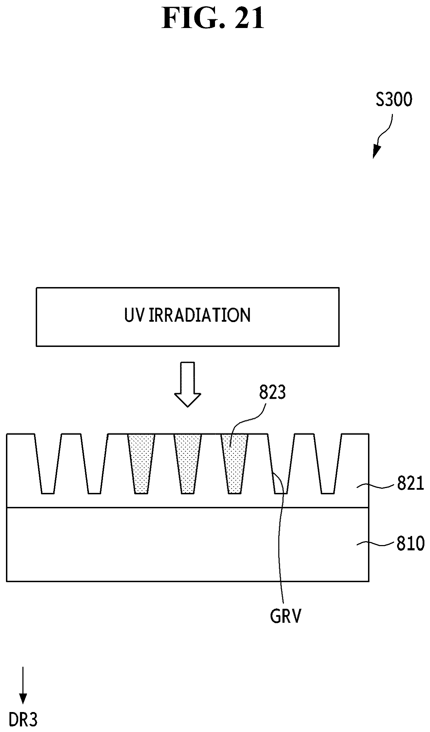

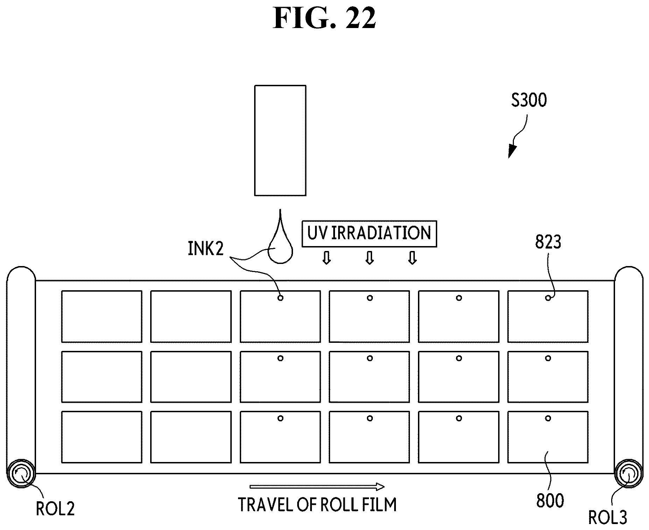

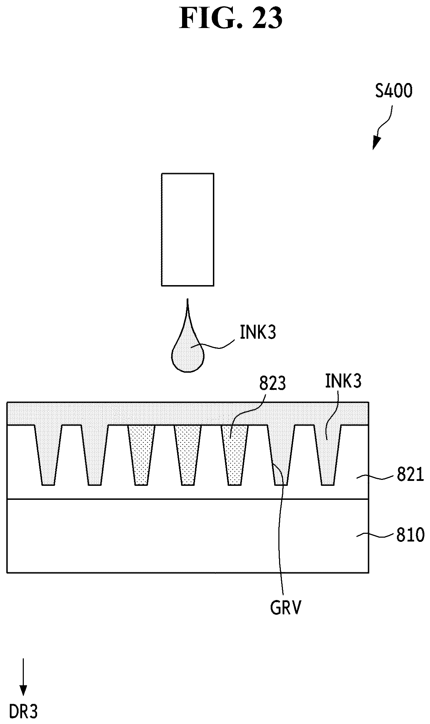

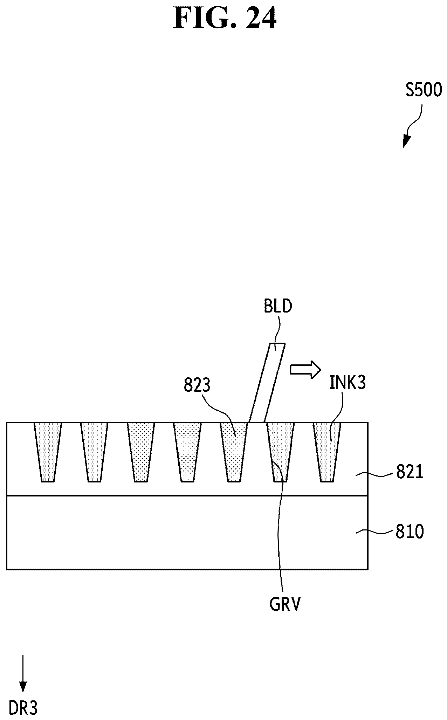

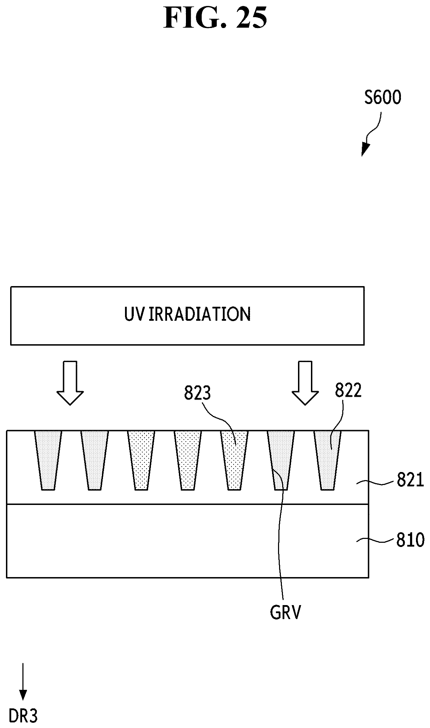

FIG. 15 is a flowchart illustrating a method for manufacturing a display device according to an embodiment. FIG. 16 is a cross-sectional view illustrating step S100 of FIG. 15. FIGS. 17 to 19 are cross-sectional views illustrating step S200 of FIG. 15. FIGS. 20 and 21 are cross-sectional views illustrating step S300 of FIG. 15. FIG. 22 is a plan view illustrating step S300 of FIG. 15. FIG. 23 is a cross-sectional view illustrating step S400 of FIG. 15. FIG. 24 is a cross-sectional view illustrating step S500 of FIG. 15. FIG. 25 is a cross-sectional view illustrating step S600 of FIG. 15. FIG. 26 is a cross-sectional view illustrating step S700 of FIG. 15.

Referring to FIGS. 15 to 26, a method (S1) for manufacturing a display device according to an embodiment may include a step (S100) of applying first ink onto a base film, a step (S200) of forming a light transmissive layer and a plurality of grooves by compressing and then curing the first ink using a mold, a step (S300) of forming a light transmitting louver by applying second ink to some of the plurality of grooves and curing the second ink, a step (S400) of applying third ink to the remaining grooves of the plurality of grooves, a step (S500) of removing the third ink overflowing from the groove using a blade, a step (S600) of forming a light blocking louver by curing the third ink, and a step (S700) of bonding a light control film to a display panel.

In the descriptions of the method and processes herein, the operations may be performed in a different order than the order shown and/or described, or the operations may be performed in different orders or at different times. Certain operations may also be left out of the flowcharts, one or more operations may be repeated, or other operations may be added. Descriptions that an element "may be disposed," "may be formed," and the like include methods, processes, and techniques for disposing, forming, positioning, and modifying the element, and the like in accordance with example aspects described herein.

First, as illustrated in FIG. 16, in the step (S100) of applying the first ink onto the base film, a base film 810 may be provided. In some embodiments, the base film 810 may include at least one of polyethylene terephthalate (PET), polycarbonate (PC), and tri-acetyl cellulose (TAC), but is not limited thereto.

The first ink INK1 may be applied onto the base film 810. The first ink INK1 may be a liquid transparent resin. For example, the first ink INK1 may include an organic film including an acryl resin, an epoxy resin, a phenolic resin, a polyamide resin, a polyimide resin, or the like.

Next, as illustrated in FIGS. 17 to 19, in the step (S200) of forming the light transmissive layer and the plurality of grooves by compressing the first ink using the mold and then curing the first ink, a mold ROL1 may be provided. In some embodiments, the mold ROL1 may be a roller or a jig. The mold ROL1 may include a pattern portion PTN. The pattern portion PTN may be a wedge pattern protruding from a body of the mold ROL1.

The first ink INK1 may be compressed using the mold ROL1. In this case, a shape of the first ink INK1 may be maintained along the shape of the pattern portion PTN of the mold ROL1.

The first ink INK1 may be cured while maintaining the shape of the first ink INK1 along the shape of the pattern portion PTN. The first ink INK1 may be cured through natural curing, heat curing, ultraviolet (UV) curing, or the like. It is illustrated in the drawing as an example that the first ink INK1 is cured through UV curing.

After the first ink INK1 is cured, the mold ROL1 may be removed. As the first ink INK1 is cured, the light transmissive layer 821 may be formed. Depending on the shape of the pattern portion PTN, a groove GRV may be formed in the light transmissive layer 821.

Next, as illustrated in FIGS. 20 to 22, in the step (S300) of forming the light transmitting louver by applying second ink to some of the plurality of grooves and curing the second ink, the second ink INK2 may be applied to some of the plurality of grooves GRV. The grooves GRV to which the second ink INK2 is applied may be grooves GRV that overlap the sub-display area SDA of the display panel 100 in the step (S700). In some embodiments, the second ink INK2 may be applied inside the groove GRV so as not to overflow from the groove GRV.

The second ink INK2 may be a liquid transparent resin. For example, the second ink INK2 may include an organic film including an acryl resin, an epoxy resin, a phenolic resin, a polyamide resin, a polyimide resin, or the like.

The second ink INK2 may include a different or identical material to the first ink INK1. In an example in which the second ink INK2 and the first ink INK1 include different respective materials, an interface between the light transmitting louver 823 and the light transmissive layer 821 may be visually recognizable due to differences in physical properties such as refractive index. In an example in which the second ink INK2 and the first ink INK1 include the same material, the interface between the light transmitting louver 823 and the light transmissive layer 821 may be visually recognizable due to a difference in particle arrangement, because the light transmissive layer 821 is cured first and then the light transmitting louver 823 is cured.

After the second ink INK2 is applied, the second ink INK2 may be cured. The second ink INK2 may be cured through natural curing, heat curing, ultraviolet (UV) curing, or the like. It is illustrated in the drawing as an example that the second ink INK2 is cured through UV curing. The second ink INK2 may be cured to form the light transmitting louver 823 in some of the grooves GRV.

In some embodiments, as illustrated in FIG. 22, by the operations of a release roller ROL2 and a take-up roller ROL3, multiple cells of light control film 800 may be manufactured at once. In this case, the second ink INK2 may be applied to each cell along a direction of travel of a roll film, and the second ink INK2 may be cured by a curing device. The application process and curing process of the second ink INK2 between adjacent cells may be simultaneously performed.

Next, as illustrated in FIG. 23, in the step (S400) of applying the third ink to the remaining grooves of the plurality of grooves, the third ink INK3 may be applied to the remaining grooves GRV of the plurality of grooves GRV. The grooves GRV to which the third ink INK3 is applied may be grooves GRV that overlap the main display area MDA of the display panel 100 in the step (S700).

In some embodiments, the third ink INK3 may be applied so as to overflow from the groove GRV. Accordingly, the third ink INK3 may be applied not only to the groove GRV but also to an upper surface of the light transmissive layer 821 and an upper surface of the light transmitting louver 823. In another embodiment, the third ink INK3 may be applied inside the groove GRV so as not to overflow from the groove GRV. Hereinafter, a case in which the third ink INK3 is applied so as to overflow from the groove GRV is described as an example.

The third ink INK3 may be a liquid light blocking resin. For example, the third ink INK3 may include an organic material including an organic black pigment such as carbon black.

Next, as illustrated in FIG. 24, in the step (S500) of removing the third ink overflowing from the groove using the blade, the blade BLD may scrape the third ink INK3 positioned on the upper surface of the light transmissive layer 821 and the upper surface of the light transmitting louver 823. Accordingly, the third ink INK3 may be removed from the upper surface of the light transmissive layer 821 and the upper surface of the light transmitting louver 823.

In another embodiment, when the third ink INK3 is applied inside the groove GRV so as not to overflow from the groove GRV, the step (S500) may be omitted.

Next, as illustrated in FIG. 25, in the step (S600) of forming the light blocking louver by curing the third ink, after the third ink INK3 is applied, the third ink INK3 may be cured. The third ink INK3 may be cured through natural curing, heat curing, ultraviolet (UV) curing, or the like. It is illustrated in the drawing as an example that the third ink INK3 is cured through UV curing. The third ink INK3 may be cured to form the light blocking louver 822 in the remainder of the grooves GRV.

Next, as illustrated in FIG. 26, in the step (S700) of bonding the light control film to the display panel, the light control film 800 may be bonded to the display panel 100 with the light transmissive layer 821, the light blocking louver 822, and the light transmitting louver 823 positioned below the base film 810. An adhesive layer PSA may be disposed below the light control film 800, and the light control film 800 and the display panel 100 may be coupled to each other by the adhesive layer PSA.

The light blocking louver 822 may overlap the main display area MDA of the display panel 100 in the third direction DR3, and the light transmissive area LTA in which the light transmitting louver 823 is disposed may overlap the sub-display area SDA of the display panel 100 in the third direction DR3.

The display device 10 according to the embodiments described herein may be applied to various electronic devices 1. The electronic device 1 according to an embodiment may include the display device 10 described herein, and may further include a module or device having additional functions in addition to the display device 10.

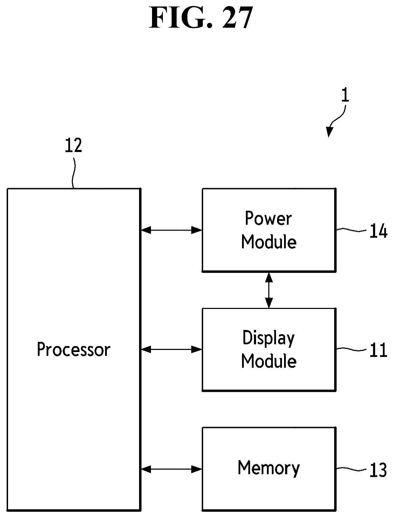

FIG. 27 is a block diagram of an electronic device according to an embodiment.

Referring to FIG. 27, an electronic device 1 according to an embodiment may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

Data information for an operation of the processor 12 or the display module 11 may be stored in the memory 13. In an example in which the processor 12 executes an application stored in the memory 13, image data signals and/or input control signals may be transmitted to the display module 11, and the display module 11 may process the provided signals and output image information through a display screen.

The power module 14 may include a power supply module, such as a power adapter or a battery device, and a power conversion module that converts power supplied by the power supply module to generate power for an operation of the electronic device 1.

At least one of the components of the electronic device 1 described herein may be included in the display device 10 according to the embodiments described herein. In some aspects, some of the individual modules functionally included within one module may be included within the display device 10, while others may be provided separately from the display device 10. For example, the display device 10 includes the display module 11, and the processor 12, the memory 13, and the power module 14 may be provided in the form of other devices within the electronic device 1 other than the display device 10.

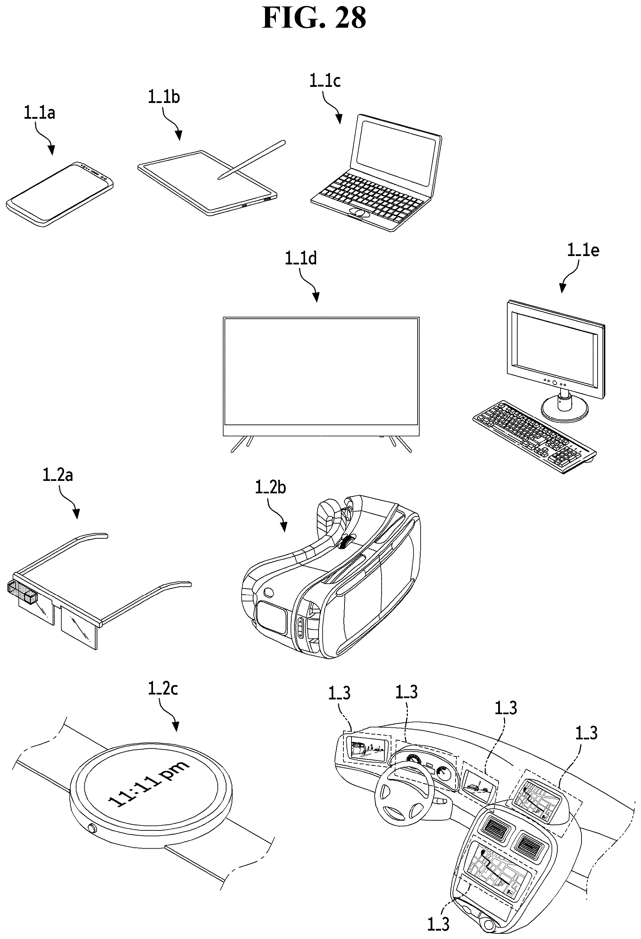

FIG. 28 illustrates schematic diagrams of electronic devices according to various embodiments.

Referring to FIG. 28, various electronic devices 1 to which the display device 10 according to the embodiments is applied may include not only an image display electronic device 1 such as a smart phone 1_1a, a tablet PC 1_1b, a laptop 1_1c, a TV 1_1d, and a desk monitor 1_1e, but also a wearable electronic device 1 including a display module such as a smart glasses 1_2a, a head mounted display 1_2b, a smart watch 1_2c, and the like, and a vehicle electronic device 1_3 including a display module such as a Center Information Display (CID), a room mirror display, or the like, disposed on a vehicle's instrument panel, center fascia, or dashboard.

In concluding the detailed description, those skilled in the art will appreciate that many variations and modifications can be made to the example embodiments without substantially departing from the principles of the present disclosure. Therefore, the disclosed example embodiments of the present disclosure are used in a generic and descriptive sense and not for purposes of limitation.

The display device achieves the significant technical advantage of simultaneously providing user privacy and enabling the functionality of under-display electronic components. The core technical effect stems from its spatially differentiated light control film. The light-blocking louvers over the main display area perform the function of a privacy screen by absorbing or blocking off-axis light, thereby controlling the viewing angle to protect sensitive information or prevent driver distraction in an automobile. Concurrently, the light-transmitting louvers over the sub-display area create a highly transparent window. This allows optical devices, such as cameras or sensors located behind the screen, to operate effectively with high light transmittance and improved sensing accuracy, a function that would be completely obstructed by a conventional privacy filter. The invention thus resolves the technical trade-off between viewing angle control and the integration of under-display components.

By forming both the light-blocking and light-transmitting louver sections within the same continuous groove, the manufacturing process is significantly simplified. This design creates a seamless optical transition between the different functional areas of the film, which prevents visual artifacts like visible lines or seams at the boundary for a more uniform appearance.

By defining the boundary between the different louver types to be larger than and surround the boundary of the sub-display area, this configuration ensures complete coverage. This prevents the light-blocking louvers from partially obscuring the edges of the underlying sensor, guaranteeing its functionality across its entire area.

Making the light-transmissive area of the film larger than the sub-display area below it provides a crucial tolerance margin for manufacturing and alignment. This ensures that even with minor misalignments during the bonding process, the underlying sensor remains fully within the transparent region, preventing performance degradation.

Forming the light-transmissive area in an elliptical shape is a direct and advantageous result of the manufacturing process. When applying a liquid resin into long, narrow grooves, capillary action causes the resin to spread further along the length of the grooves, naturally forming an elliptical transparent zone without requiring a complex elliptical mold.

Aligning the long axis of the elliptical transparent area with the extension direction of the grooves is a natural consequence of the manufacturing method. This configuration maximizes the spread of the transparent resin due to capillary forces, allowing for the creation of a larger transparent area with a simpler and more efficient process.

By orienting the louvers at an angle relative to the alignment of the display's pixels, the formation of Moiré interference patterns is suppressed. This technical effect prevents distracting visual artifacts that can occur when two regular grid patterns are overlaid, thereby improving the visual quality and clarity of the display.

Specifying that the intersection angle between the louvers and the pixels is small, specifically less than 30 degrees, provides an optimal balance. This small angle is effective at preventing Moiré patterns while ensuring that the louvers do not appear visibly slanted to the user, maintaining a clean and aesthetically pleasing appearance.

Including a transmissive area within the sub-display area, where no light-emitting elements or circuitry are placed, increases the overall light transmittance of that region. This design maximizes the amount of light that can pass through to the underlying sensor, further enhancing its sensitivity and performance.

By aligning the light-transmitting louver of the film to overlap with the inherently transmissive area of the display panel, the light path to the sensor is optimized. This synergistic combination ensures maximum light throughput by creating a clear channel through both the film and the display stack, leading to the highest possible sensing accuracy.

Incorporating an optical device, such as a sensor, positioned to align with the light-transmitting louver realizes the primary purpose of the invention. This configuration enables the seamless integration of under-display components without compromising their function, allowing for a modern, all-screen display design.

By precisely aligning the optical device to overlap with both the transmissive area of the display panel and the light-transmitting louver of the film, the system achieves maximum efficiency. This ensures the clearest possible optical path for the device, maximizing its performance and sensitivity by minimizing any potential obstruction.

Reducing the density of light-emitting elements in the sub-display area compared to the main display area creates more non-emissive space. This directly increases the overall light transmittance of that region, further improving the performance and sensitivity of the underlying optical device.

Ensuring the louvers are fully embedded within the light-transmissive layer, so they do not reach the interface with the base film, provides a planar and structurally stable surface. This continuous top layer protects the louver structures and simplifies the process of bonding additional films or a cover window, improving manufacturing reliability.

This manufacturing method enables the efficient creation of a functionally patterned light control film. By first molding a uniform groove structure and then sequentially filling different regions with transparent and light-blocking resins, it allows for the precise fabrication of distinct optical zones on a single substrate, streamlining production.

Applying an excess of the light-blocking ink and subsequently removing it from the top surface with a blade is a simple and effective planarization technique. This ensures that the grooves are completely filled while leaving a clean, flat surface, which is a reliable and high-throughput method for manufacturing.

Using a roller as the mold for creating the grooves enables a continuous roll-to-roll manufacturing process. This greatly increases production efficiency and throughput compared to batch processing with a static jig, making the technology cost-effective for mass production.

By using a mold with a predefined pattern and curing the ink while it conforms to that pattern, precise and repeatable microstructures are formed. This molding technique is fundamental to creating the louver grooves with high fidelity and is a scalable method for fabricating micro-optical structures.

Bonding the completed light control film to the display panel with an adhesive layer provides a robust and optically clear final assembly. The adhesive ensures a permanent, gap-free interface, which is critical for preventing internal reflections and maintaining the high optical performance of the display device.

Integrating the display device into an automobile dashboard provides enhanced safety and privacy. The controlled viewing angle can prevent distracting entertainment content on a passenger-side screen from being visible to the driver, and it can also reduce glare by preventing images on the driver's display from reflecting onto the windshield at night.

## Claims

1. A display device (10) comprising:
a display panel (100) comprising a main display area (MDA) and a sub-display area (SDA) surrounded by the main display area (MDA), each of the main display area (MDA) and the sub-display area (SDA) comprising a plurality of light emitting elements (170); and
a light control film (800) disposed on the display panel (100) and comprising:
a base film (810),
a light transmissive layer (821) disposed on the base film (810) and comprising a plurality of grooves (GRV), and
a plurality of louvers (822, 823) respectively disposed within the plurality of grooves (GRV),
wherein the plurality of louvers comprise a light transmitting louver (823) overlapping the sub-display area (SDA) and a light blocking louver (822) overlapping the main display area (MDA).

2. The display device (10) of claim 1, wherein grooves (GRV) overlapping both the main display area (MDA) and the sub-display area (SDA) among the plurality of grooves (GRV) comprise both the light transmitting louver (823) and the light blocking louver (822).

3. The display device (10) of claim 2, wherein a first boundary line (L1) that separates the main display area (MDA) and the sub-display area (SDA) is surrounded by a second boundary line (L2) connecting boundaries of the light transmitting louver (823) and the light blocking louver (822).

4. The display device (10) of claim 3, wherein a light transmissive area (LTA) defined by the second boundary line (L2) is greater than the sub-display area (SDA).

5. The display device (10) of claim 4, wherein the light transmissive area (LTA) defined by the second boundary line (L2) is elliptical in a plan view.

6. The display device (10) of claim 5, wherein the light transmissive area (LTA) has a long axis in an extension direction (DR4) of the grooves (GRV) in the plan view.

7. The display device (10) of any one of claims 1 to 6, wherein in the plan view, a first direction (DR1, DR2) in which the plurality of light emitting elements (170) are aligned in the main display area (MDA) and the sub-display area (SDA) intersects a second direction (DR4) in which the plurality of louvers (822, 823) extend.

8. The display device (10) of claim 7, wherein an angle (θ1) formed by the first direction and the second direction is less than 30 degrees.

9. The display device (10) of any one of claims 1 to 8, wherein the sub-display area (SDA) further comprises a transmissive area (TA) disposed between the plurality of light emitting elements (170).

10. The display device (10) of claim 9, wherein the light transmitting louver (823) overlaps the transmissive area (TA).

11. The display device (10) of claim 10, further comprising an optical device (500) overlapping the sub-display area (SDA),
wherein the optical device (500) overlaps the light transmitting louver (823).

12. The display device (10) of claim 11, wherein:
the sub-display area (SDA) further comprises a transmissive area (TA) disposed between the plurality of light emitting elements (170), and
the optical device (500) overlaps the transmissive area (TA).

13. The display device (10) of any one of claims 1 to 12, wherein a density of the plurality of light emitting elements (170) in the sub-display area (SDA) is smaller than a density of the plurality of light emitting elements (170) in the main display area (MDA).

14. The display device (10) of any one of claims 1 to 13, wherein upper surfaces of the plurality of louvers (822, 823) are spaced apart from an interface between the base film (810) and the light transmissive layer (821).

15. A method for manufacturing a display device (10), the method comprising:
providing a display panel (100) comprising a main display area (MDA) and a sub-display area (SDA) surrounded by the main display area (MDA), and providing a light control film (800) comprising a base film (810);
applying a first ink (INK1) comprising a liquid transparent resin onto the base film (810);
forming a light transmissive layer (821) and a plurality of grooves (GRV) by compressing and curing the first ink (INK1) using a mold (ROL1);
forming a light transmitting louver (823) by applying a second ink (INK2) comprising a liquid transparent resin to first grooves overlapping the sub-display area (SDA) among the plurality of grooves (GRV) and curing the second ink (INK2);
forming a light blocking louver (822) by applying a third ink (INK3) comprising a liquid transparent resin to second grooves overlapping the main display area (MDA) among the plurality of grooves (GRV) and curing the third ink (INK3); and
bonding the light control film (800) to the display panel (100).

16. The method of claim 15, wherein:
the third ink (INK3) is applied such that the third ink (INK3) is positioned on an upper surface of the light transmissive layer (821) and an upper surface of the light transmitting louver (823), and
the method further comprises removing the third ink (INK3) positioned on the upper surface of the light transmissive layer (821) and the upper surface of the light transmitting louver (823) using a blade (BLD).

17. The method of claim 16, wherein the mold (ROL1) comprises a roller or a jig.

18. The method of claim 17, wherein:
the mold (ROL1) comprises a pattern portion (PTN), and
the first ink (INK1) is cured along a shape of the pattern portion (PTN).

19. The method of claim 18, wherein the light control film (800) and the display panel (100) are bonded to each other by an adhesive layer (PSA) interposed between the light control film (800) and the display panel (100).

20. An automobile comprising:
a body;
an interior space surrounded by the body and comprising a dashboard; and
a display device (10) according to any one of claims 1 to 14 disposed on the dashboard and which displays an image.
